# EUROPÄISCHE PATENTSCHRIFT

(11) **EP 3 275 040 B1**
(45) Veröffentlichungstag und Bekanntmachung des Hinweises auf die Patenterteilung: **08.05.2019**
(21) Anmeldenummer: 16715259.4
(22) Anmeldetag: 23.03.2016
(51) Int. Cl.: H01M 10/44

(54) **VERFAHREN UND VORRICHTUNG ZUM FORMIEREN EINER BATTERIE**
METHOD AND DEVICE FOR FORMING A BATTERY
PROCÉDÉ ET DISPOSITIF DE FORMATION D'UNE BATTERIE

(30) Priorität: 23.03.2015 DE 102015205228
(43) Veröffentlichungstag der Anmeldung: 31.01.2018
(73) Patentinhaber: Fraunhofer-Gesellschaft zur Förderung der angewandten Forschung e.V., 80686 München (DE)
(72) Erfinder: BRUCH, Maximilian, 89343 Jettingen-Scheppach (DE); LUX, Stephan, 79312 Emmendingen (DE); VETTER, Matthias, 79117 Freiburg (DE)
(74) Vertreter: Zimmermann, Tankred Klaus
(86) Internationale Anmeldenummer: PCT/EP2016/056470
(87) Internationale Veröffentlichungsnummer: WO 2016/151058

(56) Entgegenhaltungen:
- JP-A- 2011 222 358
- US-A1- 2014 159 674
- US-A1- 2015 060 290

## Beschreibung

Die vorliegende Erfindung bezieht sich auf eine Vorrichtung zum Formieren einer Batterie und auf Verfahren zum Formieren einer Batterie. Die vorliegende Erfindung bezieht sich ferner auf ein Verfahren zur verbesserten Formierung von galvanischen Zellen bzw. elektrischen Batteriezellen, die eine feste Elektrolytgrenzfläche (Solid Electrolyte Interface-SEI) bilden und auf ein optimiertes Verfahren zur Formierstromführung.

Ein Fertigungsschritt bei der Herstellung von galvanischen Zellen bzw. elektrischen Batteriezellen ist die Formierung. Als Formierung werden die ersten Lade- und Entladevorgänge bezeichnet, bei denen sich die sogenannte SEI (Solid Elektrolyte Interface-SEI, feste Elektrolytgrenzfläche) bildet. Dieser Vorgang ist zur Aktivierung der elektrochemischen Prozesse und/oder Eigenschaften der Batteriezelle notwendig. Die Ausbildung der SEI spielt für wichtige Zelleigenschaften, wie Innenwiderstand und Zyklenfestigkeit eine entscheidende Rolle. Von Vorteil ist eine stabile, gleichmäßige Schicht. Dabei wird bisher mit sehr geringen elektrischen Strömen formiert (d. h. geladen und entladen). Dies wiederum führt zu einem zeitaufwendigen und somit kostenintensiven Fertigungsschritt, der den Durchsatz der Produktionskette einschränken kann.

Heutzutage bekannte Verfahren setzen auf konstante, geringe Ströme, die eine langsame gleichmäßige SEI-Bildung ermöglichen sollen. Pro Lade- bzw. Entladevorgang wird bis zur jeweiligen Schlussspannung ein fester elektrischer Strom eingestellt. In Veröffentlichungen [1] und [2] wird eine Erhöhung des Stroms ab einer vordefinierten Spannungsschwelle vorgeschlagen, wobei zwischen den ein bis drei Stufen ein konstanter Strom angewandt wird. Anfangs wird eine möglichst niedrige Stromstärke (meist 1/20 C, 1/15 C oder 1/10 C festgelegt, die auf Erfahrungswerten beruht. Bei weiter entwickelten Verfahren wird der Strom ab einer Spannungsschwelle erhöht oder die Formierung dort bereits beendet, da in Experimenten gezeigt wurde, dass danach weniger SEI gebildet wird und das Beenden verkraftbare negativen Auswirkungen auf die Zyklenfestigkeit aufweist. Ein derartiges Vorgehen ist beispielsweise in [3] beschrieben. Hier wird eine teilweise Beschleunigung des Verfahrens erreicht, indem eine geringe Verschlechterung der SEI-Homogenität oder SEI-Dicke in Kauf genommen wird.

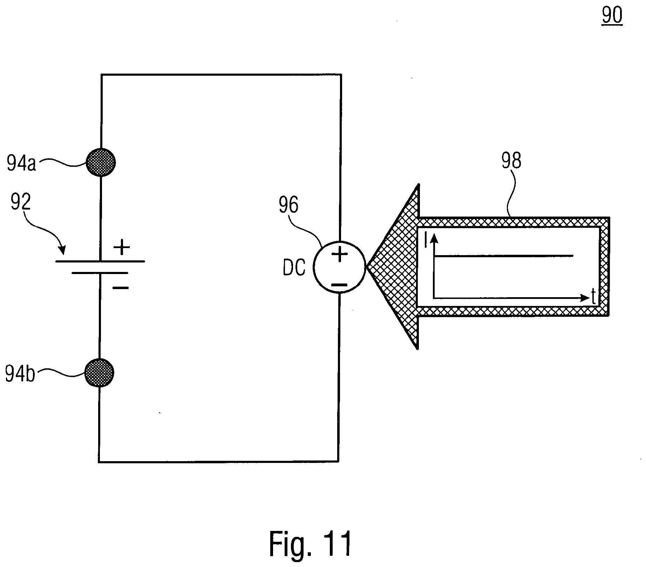

Fig. 11 zeigt eine schematische Darstellung eines Konzepts 90 zum Formieren einer Batteriezelle 92 gemäß dem Stand der Technik. Die Batteriezelle 92 ist über Kontaktierungen 94a und 94b mit einer Gleichstromquelle 96 elektrisch verbunden. Die Formierung wird mit einem konstanten Strom I vorgenommen. Wie es [1] und [2] beschrieben ist, kann der Strom I mittels einer Steuerung 98 auch so gesteuert werden, dass er in wenigen, vordefinierten Stufen erhöht wird, wobei zwischen den Stufen ein konstanter Stromwert eingestellt wird.

In US 2015/0060290 A1 ist ein Konzept beschrieben, bei dem eine geringe Stromstärke bis zu einem vorher definierten Punkt verwendet wird und danach auf eine höhere, zweite Stromstärke umgestellt wird.

In DE 3736069 A1 ist die Anwendung eines geregelten Stroms zur Formierung von Blei-Säure-Batterien beschrieben. Jedoch wird hier, wenn vergleichsweise die Formierung galvanischer Zellen herangezogen wird, ein verschiedenes elektrochemisches Ziel verfolgt. Bei einer Formierung von Blei-Säure-Batterien findet der Aufbau einer aktiven Schicht statt. Der Aufbau einer SEI umfasst eine Bildung einer elektrisch isolierenden Schicht zwischen aktiven Partikeln (Elektrode) und dem Elektrolyt. Die elektrochemischen Prozesse sind nicht vergleichbar.

Wünschenswert wäre demnach ein Konzept zum Formieren einer Batterie, das es ermöglicht, gegenüber bekannten Verfahren eine verbesserte Formierung von Batterien mit einem geringen Zeitaufwand auszuführen und/oder eine SEI mit einer hohen Homogenität zu erhalten.

Eine Aufgabe der vorliegenden Erfindung besteht darin, ein Konzept zu schaffen, das ein Formieren einer Batterie mit einem geringen Zeitaufwand und/oder einer hohen SEI-Homogenität ermöglicht.

Diese Aufgabe wird durch den Gegenstand der unabhängigen Patentansprüche gelöst.

Der Kerngedanke der vorliegenden Erfindung besteht darin, erkannt zu haben, dass obige Aufgabe dadurch gelöst werden kann, indem eine Energiemenge, die einer Batterie während eines Formierungsvorgangs zugeführt wird, dynamisch basierend auf einer Betrachtung einer tatsächlichen SEI-Bildung über einen zeitlichen Verlauf des Formierungsprozesses hinweg bestimmt werden kann. Die so bestimmte Energiemenge ermöglicht eine über den zeitlichen Verlauf hohe Anpassung der Formierstromstärke an die SEI-Bildung und/oder eine Einstellung der Energiemenge so dass die Bildung der SEI homogen erfolgt.

Eine Erkenntnis der vorliegenden Erfindung besteht darin, dass die SEI-Bildung während der Zufuhr einer Energiegröße an die zu formierende Batterie ungleichmäßig erfolgen kann. Die Ungleichmäßigkeit kann zu veränderlichen SEI-Bildungsraten und/oder ungleichmäßiger Schichthomogenität führen. Eine Anpassung der Energiemenge an den tatsächlichen Zustand der zu formierenden Batterie ermöglicht eine zumindest zeitweise Beschleunigung des Formierungsprozesses und/oder eine zumindest zeitweise Ausbildung der SEI mit einer hohen Homogenität, so dass insgesamt eine SEI mit einer hohen Schichthomogenität schnell erhalten werden kann.

Eine während der Formierung zuzuführende Energiemenge kann basierend auf einem Vergleich einer Energieaufnahme zwischen einem ersten Ladezyklus und einem zweiten Ladezyklus der Batterie bestimmt werden kann. Eine Abweichung zwischen dem ersten und dem zweiten Verlauf einer Energieaufnahme in einem Zeitintervall ermöglicht Rückschlüsse auf einen Umfang in dem SEI, während dieses Zeitintervalls gebildet wird, so dass eine dynamische Anpassung der an die Batterie zu liefernden Energiemenge erfolgen kann.

Vereinfacht ausgedrückt, können vorangehend beschriebene Ziele durch einen angepassten, dynamischen oder schwankenden Lade- und/oder Entladestrom erreicht werden.

Gemäß einem Ausführungsbeispiel umfasst ein Verfahren zum Bestimmen eines Referenzenergieprofils ein Vergleichen eines ersten Verlaufs, der eine Energieaufnahme einer ersten Batterie während eines ersten Ladezyklus beschreibt, mit einem zweiten Verlauf, der die Energieaufnahme der ersten oder einer zweiten Batterie während eines zweiten Ladezyklus, der auf den ersten Ladezyklus folgt, beschreibt. Der Vergleich wird für eine Vielzahl von Zeitintervallen ausgeführt. Das Verfahren umfasst ferner ein Bestimmen einer Abweichung zwischen dem ersten und dem zweiten Verlauf für jedes der Vielzahl von Zeitintervallen. Das Verfahren umfasst ferner ein Bestimmen einer elektrischen Energiemenge basierend auf der Abweichung für jedes der Zeitintervalle, wobei die elektrische Energie eine Sollvorgabe des Referenzenergieprofils für eine einer zu formierenden Batterie zuzuführende Energiemenge während eines Formierungsprozesses der zu formierenden Batterie für jedes der Zeitintervalle beschreibt. Mittels einer Formierung vorangehender Berechnungen zur Erstellung des Referenzenergieprofils kann somit für gleiche oder ähnliche Batterien ein Referenzenergieprofil erhalten werden, das in zumindest einem, mehreren oder allen Zeitintervallen ein hohes Maß an SEI-Bildung ermöglicht, so dass eine Zeitdauer, bis die Formierung abgeschlossen ist, kurz und damit eine Zeiteffizienz der Formierung hoch sein kann. Alternativ oder zusätzlich kann basierend auf der Anpassung der zugeführten Energiemenge eine gleichmäßige SEI-Bildung erhalten werden, so dass die SEI mit einer hohen Qualität erhalten wird.

Gemäß einem weiteren Ausführungsbeispiel umfasst ein Verfahren zum Bestimmen eines Referenzenergieprofils ein Vergleichen eines ersten Verlaufs, der eine Energieaufnahme einer ersten Batterie während eines ersten Ladezyklus beschreibt, mit einem zweiten Verlauf, der die Energieaufnahme der ersten oder zweiten Batterie während eines zweiten Ladezyklus, der auf den ersten Ladezyklus folgt, beschreibt. Der Vergleich wird für eine Vielzahl von Zeitintervallen ausgeführt. Das Verfahren umfasst ferner ein Bestimmen einer Abweichung zwischen dem ersten und dem zweiten Verlauf für jedes der Vielzahl von Zeitintervallen. Das Verfahren umfasst ferner ein Bestimmen, dass eine elektrische Energiemenge, die einer weiteren Batterie während einer Formierung derselben zugeführt wird, in einem nachfolgenden Zeitintervall reduziert ist, basierend auf dem Vergleich, wenn der Vergleich anzeigt, dass ein Ausmaß einer Formierung, die von der elektrischen Energie bewirkt wird, kleiner oder gleich als 80 % einer durch die elektrische Energie bewirkbaren Formierung ist. Der Verlauf der elektrischen Energiemenge über die Vielzahl von Zeitintervallen beschreibt das Referenzenergieprofil zumindest teilweise. Eine Abweichung zwischen den Verläufen kann einen Hinweis darauf liefern, dass ein Anteil von größer als 20 % der elektrischen Energie in eine Aufladung der Batterie und mithin nicht für die Bildung der SEI aufgewendet wird. Basierend auf einer Reduzierung der elektrischen Energiemenge, die an die zu formierende Batterie geführt wird, kann der Anteil reduziert werden, so dass eine schnelle und/oder mit einer hohen Qualität erhaltene SEI gebildet wird.

Erfindungsgemäß wird ein Referenzenergieprofil gemäß vorangehenden Ausführungsbeispielen verwendet, um die elektrische Energie gemäß dem Referenzenergieprofil an die zu formierende Batterie anzulegen.

Gemäß einem weiteren Ausführungsbeispiel umfasst eine Vorrichtung zum Formieren einer Batterie eine steuerbare Energiequelle, die ausgebildet ist, um eine elektrische Energie an eine mit der steuerbaren Energiequelle gekoppelte Batterie zu liefern. Die Vorrichtung umfasst eine Steuereinrichtung, die ausgebildet ist, um die steuerbare Energiequelle in einer Vielzahl von Zeitintervallen zu steuern. Die Vorrichtung umfasst ferner eine Erfassungseinrichtung, die ausgebildet ist, um einen physikalischen Zustand der Batterie in jedem der Zeitintervalle zu bestimmen. Die Steuereinrichtung ist ausgebildet, um basierend auf dem erfassten physikalischen Zustand die elektrische Energiequelle so zu steuern, dass eine Menge an elektrischer Energie, die während eines folgenden Zeitintervalls an die Batterie geliefert wird, erhöht oder gesenkt wird. Vorteilhaft an diesem Ausführungsbeispiel ist, dass basierend auf einer Steuerung der elektrischen Energiequelle basierend auf einem aktuellen physikalischen Zustand der Batterie eine Variation zwischen einzelnen Batterien berücksichtigt werden kann, so dass für jede einzelne Batterie ein schneller und/oder hochqualitativer Formierungsprozess ausgeführt werden kann. Weitere Ausführungsbeispiele beziehen sich auf ein Computerprogramm und auf ein Verfahren zum Formieren einer Batterie.

Weitere vorteilhafte Ausführungsformen sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
Fig. 1 ein schematisches Flussdiagramm eines Verfahrens zum Bestimmen eines Referenzenergieprofils gemäß einem Ausführungsbeispiel;
Fig. 2 ein schematisches Flussdiagramm eines weiteren Verfahrens zum Bestimmen eines Referenzenergieprofils gemäß einem Ausführungsbeispiel;
Fig. 3 ein schematisches Flussdiagramm eines Verfahrens zum Bestimmen einer elektrischen Energiemenge gemäß einem Ausführungsbeispiel;
Fig. 4 ein schematisches Diagramm, in dem ein Ausschnitt eines ersten Verlaufs und ein Ausschnitt eines zweiten Verlaufs eines Ladezyklus dargestellt ist gemäß einem Ausführungsbeispiel;
Fig. 5 ein schematisches Flussdiagramm eines Verfahrens zum Formieren einer Batterie gemäß einem Ausführungsbeispiel;
Fig. 6 ein schematisches Blockschaltbild einer Vorrichtung zur Verwendung eines Referenzenergieprofils gemäß einem Ausführungsbeispiel;
Fig. 7 ein schematisches Blockschaltbild einer Vorrichtung zum Formieren der Batterie gemäß einem Ausführungsbeispiel;
Fig. 8 ein schematisches Blockschaltbild einer Vorrichtung, die gegenüber der Vorrichtung aus Fig. 7 einen Speicher aufweist, der ausgebildet ist, um ein Referenzenergieprofil zu speichern, gemäß einem Ausführungsbeispiel;
Fig. 9 ein schematisches Diagramm mit einem Verlauf einer Batteriespannung während eines Formierungsprozesses, wie es gemäß einem Aspekt hierin beschriebener Ausführungsbeispiele erhalten werden kann;
Fig. 10 ein schematisches Flussdiagramm eines Verfahrens zum Formieren einer Batterie gemäß einem Ausführungsbeispiel;
Fig. 11 eine schematische Darstellung eines Konzepts zum Formieren einer Batteriezelle gemäß dem Stand der Technik;
Fig. 12a-b schematische Darstellungen von Verfahren zum Formieren einer Batterie durch Verwendung eines Referenzenergieprofils gemäß hierein beschriebener Ausführungsbeispiele; und
Fig. 12c-d schematische Darstellungen von Verfahren zum Formieren einer Batterie durch Anpassen eines Normprofils gemäß hierein beschriebener Ausführungsbeispiele.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele beziehen sich teilweise auf die Bestimmung einer elektrischen Energie, die für die Zwecke der Formierung einer Batterie zugeführt wird. Obwohl sich Ausführungsbeispiele darauf beziehen, einen Verlauf von Eigenschaften oder physikalischen Zuständen der Batterie und/oder Bestimmung einer elektrischen Energiemenge für einen Ladevorgang der Batterie zu bestimmen, sind nachfolgende Erläuterungen ohne relevante Einschränkungen auch auf einen Entladevorgang der Batterie anwendbar. Während einer Formierung einer Batterie kann bspw. eine vorgegebene Stromstärke an die Batterie angelegt werden. Eine positive Stromstärke kann zu einer Ladung der Batterie führen, während eine negative Stromstärke zu einer Entladung der Batterie und/oder einer negativen Aufladung der Batterie führen kann, wobei eine SEI-Bildung während der Ladung und der Entladung erfolgen kann. Vereinfacht ausgedrückt kann der nachfolgend als Laden beschriebene Vorgang ein Laden oder Entladen der Batterie beschreiben, wobei der nachfolgend als Entladen beschriebene Vorgang lediglich als der komplementäre Vorgang, d. h., als Entladevorgang bzw. als Ladevorgang verstanden werden soll. Eine nachfolgend als Energiemenge, die einer Batterie zugeführt wird, kann, etwa basierend auf einer negativen Stromstärke, auch negativ sein. Dies kann dazu führen dass bei zugeführter Energiemenge Ladungsträger aus der Batterie abgeführt werden.

Obwohl sich nachfolgende Ausführungsbeispiele teilweise auf die Bestimmung und/oder Verwendung eines Referenzstromprofils beziehen, das Informationen bezüglich eines von einer steuerbaren Energiequelle bereitzustellenden Stroms aufweist, beziehen sich andere Ausführungsbeispiele auf eine Bestimmung und/oder Verwendung eines Referenzenergieprofils, das eine Information bezüglich einer an die zu formierende Batterie bereitzustellenden elektrischen Energie aufweist. Hierbei kann es sich bspw. um eine bereitzustellende Ladungsmenge und/oder eine elektrische Spannung handeln, die von einer steuerbaren Energiequelle bereitgestellt wird. Ist bspw. ein (Shunt-)Widerstand der Vorrichtung bekannt, kann dies in den an die zu formierende Batterie zu führenden Strom überführt sein. Das Referenzenergieprofil kann somit eine Information über die bereitzustellende elektrische Energie aufweisen. Die elektrische Energie kann sich auf einen elektrischen Strom, auf eine elektrische Spannung, auf eine elektrische Ladung und/oder auf eine Menge von elektrischen Ladungsträger beziehen.

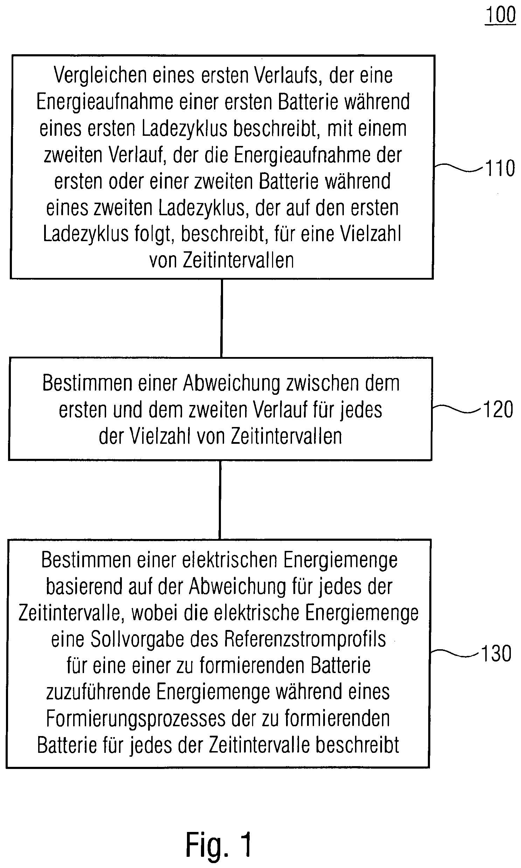

Fig. 1 zeigt ein schematisches Flussdiagramm eines Verfahrens 100 zum Bestimmen eines Referenzenergieprofils (Referenzstromprofils) gemäß einem Ausführungsbeispiel. Das Verfahren umfasst einen Schritt 110, in dem ein erster Verlauf mit einem zweiten Verlauf verglichen wird. Der erste Verlauf beschreibt eine Energieaufnahme (bspw. eine Ladungsträgerzunahme, Ladungsträgerabnahme und/oder ein hiervon abgeleiteter Wert) einer ersten Batterie während eines ersten Ladezyklus. Der zweite Verlauf beschreibt eine Energieaufnahme derselben oder einer anderen Batterie während eines zweiten Ladezyklus. Der zweite Ladezyklus folgt auf den ersten Ladezyklus. Beispielsweise kann es sich bei dem ersten Ladezyklus um den tatsächlich ersten (initialen) Ladezyklus handeln, während dem die Formierung der Batterie zumindest teilweise ausgeführt wird. Bei dem zweiten Ladezyklus kann es sich um einen nachfolgenden Ladezyklus handeln, während dem die Batterie erneut geladen wird. Das bedeutet, dass zwischen dem ersten und dem zweiten Ladezyklus zumindest ein komplementärer Entladezyklus ausgeführt werden kann, so dass die Batterie in dem zweiten Ladezyklus erneut geladen werden kann.

Der zweite Ladezyklus kann der auf den ersten Entladezyklus folgende tatsächliche zweite Ladezyklus oder alternativ ein anderer (bspw. dritter, vierter, fünfter oder weiterer) mit dem ersten Ladezyklus vergleichbarer Ladezyklus sein. Vorteilhaft ist eine Verwendung des zweiten Ladezyklus, da hier der Vergleich zwischen den Ladezyklen lediglich durch einen Entladezyklus beabstandet ist. Der Vergleich wird für eine Vielzahl von Zeitintervallen ausgeführt. Die Vielzahl von Zeitintervallen kann sich dabei auf eine Zeitspanne beziehen, in der die Formierung, d. h. die Bildung der SEI in der Batterie stattfindet. Vereinfach ausgedrückt kann der zweite Verlauf einer zumindest teilweise oder vollständig formierten Batterie und der erste Verlauf einer zumindest in einem geringeren Umfang oder nicht formierten Batterie zugeordnet werden.

Bei den Zeitintervallen kann es sich um eine Zeit(spanne) handeln, die während eines Zeitabschnitts des Ladezyklus vergeht. Alternativ oder zusätzlich kann es sich bei dem Zeitintervall um eine Zeitdauer handeln, während der die erste oder zweite Batterie einen bestimmten oder innerhalb eines Toleranzbereichs unveränderten physikalischen Zustand aufweist. Bei dem physikalischen Zustand kann es sich beispielsweise um eine Spannung handeln, die zwischen Polen der Batterie anliegt (abgreifbar ist). Alternativ oder zusätzlich kann es sich bei dem physikalischen Zustand um eine Stromstärke handeln, die von der Batterie aufgenommen wird oder von dieser freigesetzt wird. Ferner kann es sich bei dem physikalischen Zustand um eine Temperatur handeln, auf die die Batterie während des Formierungsprozesses gebracht wird bzw. eine Temperatur die die Batterie selbst aufweist. Alternativ oder zusätzlich ist ebenfalls vorstellbar, dass es sich bei dem physikalischen Zustand um eine oder mehrere hiervon abgeleitete Größen handelt. Beispielsweise kann es sich hier um eine Spannungsänderung zwischen Polen der Batterie handeln, die in Relation zu einer aufgenommenen Ladungsmenge gesetzt wird. Das bedeutet, dass unter Zeitintervall beispielsweise auch eine Zeitdauer oder ein Zeitpunkt verstanden werden kann, während dem die Batterie den jeweiligen physikalischen Zustand unverändert oder innerhalb eines Toleranzbereichs unverändert aufweist. Der Toleranzbereich kann bspw. innerhalb einer Abweichung von höchstens 20%, höchstens 10% oder höchstens 5% des Wertes des ersten oder zweiten Verlaufs betragen.

Das Verfahren 100 umfasst einen Schritt 120, in dem eine Abweichung zwischen dem ersten und dem zweiten Verlauf für jedes der Vielzahl von Zeitintervallen bestimmt wird. Die Abweichung kann basierend auf einer mathematischen Operation, wie etwa einer Differenzbildung, einer Quotientenbildung oder dergleichen erfolgen. Beispielsweise kann eine Differenz zwischen der Energieaufnahme des ersten Verlaufs in einem Zeitintervall und einer Energieaufnahme des zweiten Verlaufs während dem gleichen oder einem vergleichbaren Zeitintervall erfolgen.

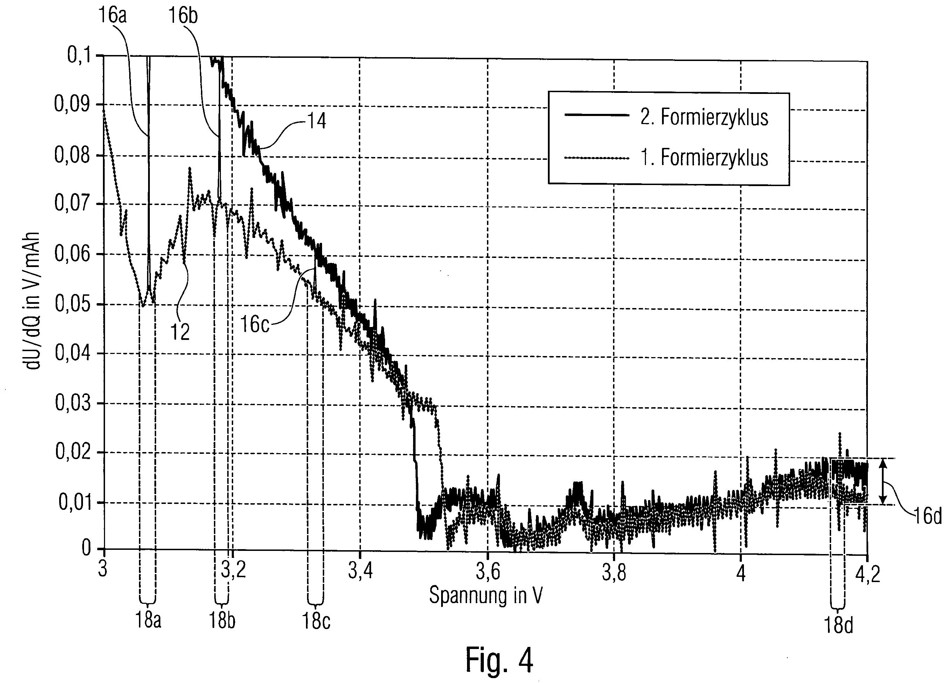

Bspw. kann sich die Energieaufnahme auf eine Spannungsänderung dU beziehen, die in Abhängigkeit einer aufgenommenen Ladungsmenge dQ an den Batteriepolen erhalten wird. Der Verlauf kann bspw. über eine monoton ansteigende Batteriespannung darstellbar sein, wie es später im Zusammenhang mit Fig. 4 erläutert wird.

Das Verfahren 130 umfasst ferner eine Bestimmung einer elektrischen Energiemenge basierend auf der Abweichung für jedes der Zeitintervalle. Die elektrische Energie beschreibt eine Sollvorgabe des Referenzstromprofils für eine Energiemenge, die einer zu formierenden Batterie während eines Formierungsprozesses der zu formierenden Batterie zugeführt werden soll für jedes der Zeitintervalle.

Beispielsweise kann sich die Abweichung auf eine auftretende Spannungsänderung pro Ladungsmenge zwischen den Verläufen beziehen. Eine große Abweichung kann eine Information darüber liefern, dass während des Zeitintervalls, in dem die Abweichung zwischen einem Verlauf, der einer zumindest teilweise formierten Batterie zugeordnet ist, und einem Verlauf der einer in einem geringeren Umfang formierten Batterie zugeordnet ist, auftritt, ein hohes Maß der bereitgestellten Energie für die Ausbildung der SEI umgesetzt wird. Eine geringe Abweichung kann eine Information darüber bereitstellen, dass die zugeführte oder abgeführte Energiemenge (Ladungsträger) zu einer geringen Ausbildung von SEI führt.

Das Referenzstromprofil kann für ein Zeitintervall, für das Informationen über ein hohes Maß an gebildetem SEI vorliegen, eine Anweisung darüber enthalten, dass eine der zu formierenden Batterie zuzuführende Energiemenge gering sein soll (bspw. in Form einer geringen Stromstärke), so dass während dieses Zeitintervalls eine homogene SEI-Bildung mit einer hohen Qualität erhalten werden kann. Für ein anderes Zeitintervall, an dem die Abweichung auf eine geringe SEI-Bildungsrate schließen lässt (etwa ein geringer Abweichungswert), kann das Referenzstromprofil eine Anweisung aufweisen, das ein hoher Strom an die zu formierende Batterie zu liefern ist. Dies kann dazu führen, dass dieses Zeitintervall schnell durchlaufen werden kann. Vereinfacht ausgedrückt kann die Abweichung so interpretiert werden, dass ein physikalischer Zustand der Batterie, in dem wenig SEI gebildet wird, schnell durchlaufen wird, während ein physikalischer Zustand in dem ein hohes Maß an SEI gebildet wird, langsam durchlaufen wird.

Vorteilhaft an diesem Ausführungsbeispiel ist, dass das so erhaltene Referenzstromprofil den aktuellen Zustand der zu formierenden Batterie berücksichtigt werden kann und dass für jedes Zeitintervall eine zu liefernde Energiemenge neu bestimmbar ist. Insbesondere kann zwischen Zeitintervallen die Energiemenge erhöht oder abgesenkt werden. Die Energiemenge kann sich beispielsweise auf eine an die zu formierende Batterie zu liefernde Stromstärke beziehen. Alternativ kann es sich beispielsweise um eine elektrische Spannung handeln, die von einer Energiequelle ausgegeben wird und gegebenenfalls über einen elektrischen Widerstand als elektrischer Strom an die Batterie geführt wird.

Das Bestimmen der elektrischen Energiemenge kann basierend auf einer Umrechnungsfunktion erfolgen. Die Umrechnungsfunktion kann zumindest ein Funktionsargument aufweisen, das auf einen Funktionswert abgebildet wird. Das Funktionsargument kann beispielsweise die bestimmte Abweichung sein. Der Funktionswert kann die elektrische Energie oder ein damit korrelierter Wert sein. Der korrelierte Wert kann ein beliebiger Wert sein, basierend auf dem eine steuerbare Energiequelle so gesteuert werden kann, dass sie ein entsprechendes Maß an elektrischer Energie bereitstellt, bspw. ein Wertindex, eine Relativgröße eines Stroms oder einer Spannung oder ein Absolutwert davon. Der Funktionswert der Umrechnungsfunktion kann eine elektrische Stromstärke oder eine elektrische Ladungsmenge beschreiben. Eine beispielhafte Umrechnungsfunktion wird anhand nachfolgend beschriebener Fig. 4 erläutert.

Bei der ersten Batterie kann es sich beispielsweise um eine Referenzbatterie oder eine Batterie aus einer Fertigungscharge handeln. In einem ersten Fall kann der erste Verlauf durch Laden (erster Ladezyklus) der ersten Batterie erfolgen. Anschließend kann die erste Batterie zumindest teilweise entladen werden und anschließend erneut geladen (zweiter Ladezyklus) werden, um den zweiten Verlauf zu erhalten. Alternativ kann zwischen dem ersten Ladezyklus und dem zweiten Ladezyklus zumindest ein weiterer Ladezyklus und/oder zumindest ein weiterer Entladezyklus angeordnet sein.

Alternativ kann der zweite Verlauf basierend auf einem Ladevorgang einer zweiten Batterie ermittelt werden. Die zweite Batterie kann beispielsweise zumindest eine gleiche oder vergleichbare Eigenschaft aufweisen, wie die erste Batterie. Die Eigenschaft kann bspw. eine Form (etwa der Batteriezelle, der Elektroden, eines Volumens, in dem Elektrolyt angeordnet ist), zumindest eine elektrische Charakteristik (Zellgröße, Ladespannung, Geometrie oder dergleichen) umfassen. Insbesondere kann es sich bei der zweiten Batterie beispielsweise um eine baugleiche Batterie handeln, die gegebenenfalls in der gleichen Fertigungscharge wie die erste Batterie hergestellt wird.

Alternativ oder zusätzlich ist ebenfalls vorstellbar, dass der erste Verlauf und/oder der zweite Verlauf jeweils einen Mittelwert über eine Vielzahl (2, 3, 4 oder mehrere) Batterien, für die jeweils der entsprechende Verlauf bestimmt wird, beschreibt. Bei dem Mittelwert kann es sich um einen geometrischen, einen quadratischen oder auch einen Median-Mittelwert handeln. Eine Mittelwertbildung ermöglicht eine hohe Übereinstimmung des Verlaufs des Referenzstromprofils über eine Vielzahl von Batterien. Alternativ oder zusätzlich können die Verläufe auch basierend auf einem Modell und/oder einer Computersimulation erstellt werden, etwa indem die Bildung der SEI basierend auf der angelegten Stromstärke nachgebildet (modelliert oder simuliert) wird.

Der erste Verlauf, der zweite Verlauf und/oder das Referenzstromprofil kann ein kontinuierlicher Verlauf, etwa in Form einer Überlagerung von Funktionen, sein. Alternativ kann der erste Verlauf, der zweite Verlauf und/oder das Referenzstromprofil eine Vielzahl diskreter Werte sein, die eine Interpolation oder Extrapolation weiterer Werte ermöglichen.

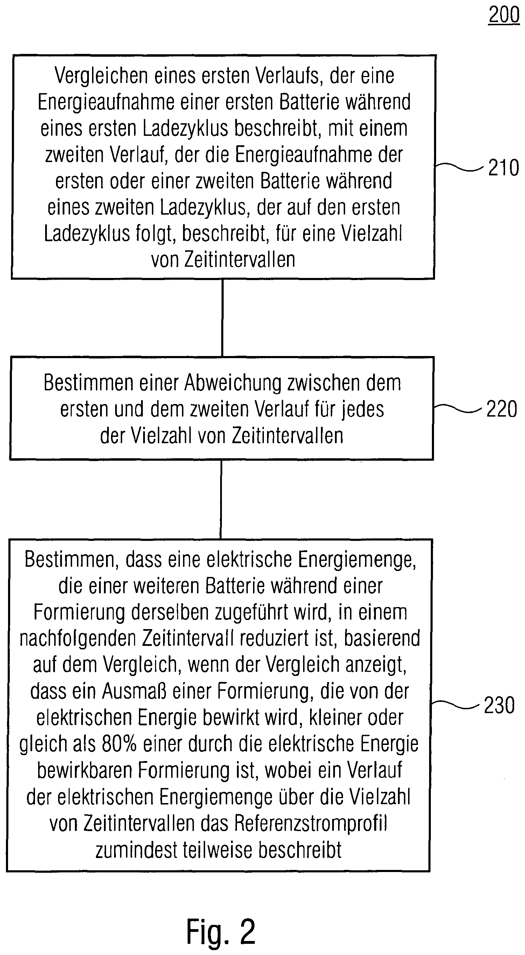

Fig. 2 zeigt ein schematisches Flussdiagramm eines Verfahrens zum Bestimmen eines Referenzstromprofils gemäß einem Ausführungsbeispiel. Das Verfahren 200 umfasst einen Schritt 210. In dem Schritt 210 wird ein erster Verlauf, der eine Energieaufnahme einer ersten Batterie während eines ersten Ladezyklus beschreibt, mit einem zweiten Verlauf verglichen. Der zweite Verlauf beschreibt die Energieaufnahme der ersten oder einer zweiten Batterie während eines zweiten Ladezyklus, der auf den ersten Ladezyklus folgt. Der Vergleich kann für eine Vielzahl von Zeitintervallen ausgeführt werden. Bei dem Schritt 210 kann es sich um den Schritt 110 handeln.

In einem Schritt 220 erfolgt ein Bestimmen einer Abweichung zwischen dem ersten und dem zweiten Verlauf für jedes der Vielzahl von Zeitintervallen, wie es für den Schritt 120 beschrieben ist.

In einem Schritt 230 des Verfahrens 200 erfolgt ein Bestimmen, dass eine elektrische Energiemenge, die einer weiteren, zu formierenden Batterie während einer Formierung derselben zugeführt wird, in einem nachfolgenden Zeitintervall reduziert ist. Dies kann basierend auf dem Vergleich erfolgen. Beispielsweise kann der Vergleich anzeigen, dass ein Ausmaß der Formierung, die von der zugeführten elektrischen Energie bewirkt wird, größer oder gleich 40 %, größer oder gleich 60 % oder größer oder gleich 80% einer durch die elektrische Energie bewirkbaren Formierung ist. Auf einen Anteil kann geschlossen werden, indem bspw. Messungen an Referenzbatterien (ggf. zu unterschiedlichen Zeitintervallen) vorgenommen werden oder Simulationen für einen entsprechenden Batterietyp durchgeführt werden. Ein Abweichungswert kann mittels einer Umrechnungsfunktion mit dem Anteil korreliert werden. Ein Verlauf der so bestimmten elektrischen Energiemenge über die Vielzahl von Zeitintervallen kann das Referenzstromprofil zumindest teilweise beschreiben. Vereinfacht ausgedrückt kann das Referenzstromprofil erhalten werden, indem die bestimmte elektrische Energiemenge über die Vielzahl von Zeitintervallen betrachtet wird.

Bekannte Verfahren sind nicht hinreichend in der Lage, zu berücksichtigen, wann die SEI-Bildung in welcher Form abläuft. Gegenüber bekannten Verfahren, bei denen eine Stromstärke konstant oder basierend auf vordefinierten Kriterien schrittweise ansteigend eingestellt wird, ermöglicht das Verfahren 200 eine Erhöhung der zugeführten Energiemenge bei Bedarf, etwa wenn gerade ein geringes Maß an SEI gebildet wird und zur Beschleunigung des Verfahrens. Das Verfahren ermöglicht ferner eine Reduzierung der Energiemenge bei Bedarf. Dieser Bedarf kann bspw. auftreten, wenn ein hohes Maß der elektrischen Energie d.h. zumindest 40%, zumindest 60% oder zumindest 80% der zugeführten elektrischen Energie in die Bildung der SEI überführt wird. Bei einer vollständigen Ladung der Batterie kann die SEI in einem höheren Umfang gebildet ist, die Ausbildung der SEI in einem homogeneren Zustand erfolgt ist und/oder der Formierungsvorgang (Ladezyklus) in einer kürzeren Zeit erfolgt ist.

Der erste und der zweite Ladezyklus können beispielsweise basierend auf einer an die Batterie angelegte Stromstärke mit einem konstanten oder vordefinierten (ggf. veränderlichen) Wert erfolgen. Die konstante Stromstärke kann einen beliebigen Wert aufweisen, beispielsweise 1/50 C, 1/30 C, 1/10 C oder einen Wert dazwischen. Der Wert 1 C beschreibt dabei einen beispielsweise in mA angegebenen Strom der Batterie. Weist die Batterie beispielsweise eine Kapazität von 2000 mAh auf, so kann 1 C einer Stromstärke von 2000 mA entsprechen.

Das Verfahren 100 und/oder 200 kann so ausgeführt werden, dass ein erster oder zweiter Verlauf einem bestimmten Lade- oder Entladevorgang zugeordnet ist. Ferner kann das Verfahren 100 und/oder 200 widerholt ausgeführt werden. Bspw. kann eine Wiederholung so ausgeführt werden, dass sich in einer ersten Wiederholung (zweite Ausführung) der erste Verlauf im Wesentlichen oder vollständig dem zweiten Verlauf einer vorangehenden Ausführung entspricht. Eine Formierung kann bspw. 2, 3, 4 oder 5 Lade- und/oder Entladezyklen umfassen. Vereinfacht ausgedrückt kann für wiederholte Lade- und Entladezyklen der Batterie jeweils ein Referenzstromprofil erstellt und/oder verwendet werden. Ein Verfahren zum Formieren einer Batterie kann in zumindest einer Wiederholung wiederholt ausgeführt werden. Der erste Verlauf und der zweite Verlauf einer jeweiligen Ausführung (erste oder weitere Ausführung des Verfahrens) kann einem Lade- oder Entladezyklus der zu formierenden Batterie zugeordnet sein. Der erste Verlauf oder der zweite Verlauf einer Wiederholung gegenüber dem ersten Verlauf kann gegenüber dem ersten bzw. zweiten Verlauf einer vorangehenden Ausführung des Verfahrens verändert sein. Bspw. kann die Ladung oder Entladung einer Batterie so oft wiederholt werden, bis die Batterie hinreichend formiert ist, etwa bei einer Anzahl von 2, 3, 4, 5 oder mehr Ladezyklen.

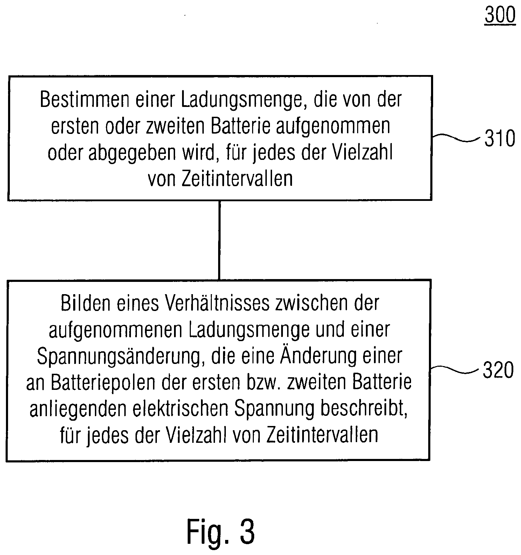

Fig. 3 zeigt ein schematisches Flussdiagramm eines Verfahrens 300 gemäß einem Ausführungsbeispiel. Das Verfahren 300 kann beispielsweise dazu benutzt werden, um das Vergleichen des ersten und zweiten Verlaufs, wie es für die Schritte 110 und 210 ausgeführt ist, auszuführen.

Das Verfahren 300 umfasst einen Schritt 310. In dem Schritt 310 wird eine Ladungsmenge bestimmt, die von der ersten oder zweiten Batterie aufgenommen wird. Die Ladungsmenge wird für jedes der Vielzahl von Zeitintervallen bestimmt.

Das Verfahren 300 umfasst einen Schritt 320. In dem Schritt 320 wird ein Verhältnis zwischen der aufgenommenen Ladungsmenge und einer Spannungsänderung, die eine Änderung einer an Batteriepolen der ersten bzw. zweiten Batterie anliegenden elektrischen Spannung beschreibt, gebildet. Das Verhältnis wird für jedes der Vielzahl von Zeitintervallen gebildet.

Fig. 4 zeigt ein schematisches Diagramm, in dem ein Ausschnitt eines ersten Verlaufs (Formierzyklus) 12 und ein Ausschnitt eines zweiten Verlaufs (Formierungszyklus) 14 dargestellt ist. Die Verläufe 12 und 14 beschreiben bspw. jeweils einen Aufladezyklus, wobei die Erläuterungen ohne Weiteres für einen Entladezyklus gelten. An der Abszisse des Diagramms ist eine monoton ansteigende elektrische Spannung in Volt angetragen. Bei der elektrischen Spannung kann es sich um eine physikalische elektrische Spannung handeln, die zwischen einem Pluspol und einem Minuspol einer Batterie anliegt bzw. abgreifbar ist. Alternativ oder zusätzlich kann es sich bei der elektrischen Spannung um ein Simulationsergebnis der physikalischen elektrischen Spannung (also bspw. einen mathematischen Wert) handeln. An der Ordinate des Diagramms ist ein Spannungsgradient dU/dQ eingetragen, der die Änderung dU der an der Abszisse eingetragenen Spannung in Relation zu einer von der jeweiligen Batterie erhaltenen Ladungsmenge dQ beschreibt. Der Spannungsgradient kann basierend auf einer bestimmten Ladungsmenge, die von der ersten oder zweiten Batterie aufgenommen wird, für jedes der Vielzahl von Zeitintervallen bestimmt werden. Die Ordinate weist die Einheit V/mAh auf. Das Diagramm kann beispielsweise erhalten werden, indem ein elektrischer Strom mit einer gegebenenfalls geringen Stromstärke an die Batterie angelegt wird. Dies kann zu einem Anstieg der Spannung (Abszisse) führen, wobei der Gradient (Änderung oder Änderungsgeschwindigkeit) an der Ordinate gezeigt ist. Die Werteangaben der Abszisse und der Ordinate sind lediglich beispielhaft und schematisch zu verstehen und sollen keine einschränkende Wirkung entfalten.

Die Verläufe 12 und 14 sind in einem beispielhaften Arbeitsbereich einer Batterie dargestellt. Der Arbeitsbereich weist beispielhaft eine Untergrenze von in etwa 3 Volt und eine Obergrenze von in etwa 4,2 Volt auf. Andere Verläufe können andere Unter- und/oder Obergrenzen aufweisen. Andere Verläufe können in zumindest einem Bereich umfassend eine andere Untergrenze (etwa in etwa 0 Volt, 1 Volt oder einen anderen Wert) und/oder eine andere Obergrenze (etwa 2 Volt, 3 Volt 5 Volt oder einen anderen Wert) bestimmt werden. Beispielsweise kann zumindest einer der Verläufe 12 oder 14 auch abschnittsweise bestimmt werden, etwa in einem Abschnitt der außerhalb des Arbeitsbereichs liegt (etwa basierend auf einer Simulation oder Referenzmessung an einer tiefenentladenen Batterie) und in einem Abschnitt innerhalb des Arbeitsbereichs (etwa durch Messung während des Ladevorgangs).

Das Diagramm weist bspw. vier Abweichungen 16a-d in zwischen dem ersten Verlauf 12 und dem zweiten Verlauf 14 in vier Zeitintervallen 18a-d auf. Wie vorangehend erläutert können die Verläufe 12 und/oder 14 in eine Vielzahl von Zeitintervallen unterteilt werden. Die Zeitintervalle können zusammengenommen einen Anteil von zumindest 20 %, zumindest 50 % oder zumindest 80 % der Lade- oder Entladezyklen umfassen, oder diese komplett umfassen. Zur vereinfachten Darstellung sind lediglich vier Zeitintervalle 18a-d dargestellt, wobei die Vielzahl von Zeitintervallen (etwa mehr als 2, mehr als 5 oder mehr als 10) über die Verläufe ggf. nahtlos aneinandergefügt werden können.

Die erste Abweichung 16a ist bei einer Spannung von in etwa 3,1 V, eine zweite Abweichung 16b bei einer Spannung von in etwa 3,17 V, eine dritte Abweichung 16c bei einer Spannung von in etwa 3,3 V und eine vierte Abweichung 16d bei einer Spannung von in etwa 4,15 V angezeichnet. Bei einer geringen Spannung (Abweichungen 16a und 16b) ist ein ladungsspezifischer Spannungsanstieg des ersten Ladezyklus (Verlaufs 12) verhältnismäßig gering.

Obwohl das Diagramm augenscheinlich einen hohen dU/dQ-Wert aufweist, kann in diesem Bereich die Spannung aufgrund der Batteriechemie stärker ansteigen, d. h., die normale Spannungssteigerung ist hier also größer. Die Referenz (also der folgende Verlauf) oder die Batterie, die einen weiter Formierten Zustand aufweist, kann also als Normale herangezogen und mit dem aktuellen oder vorrausgehenden Zyklus verglichen werden, um die SEI Bildung (der die beiden Kurven variieren lässt) abzuschätzen.

Das bedeutet, es ist eine große Differenz (Abweichung) 16a vorhanden. Dies ermöglicht einen Rückschluss darauf, dass eine starke SEI-Bildung stattfindet. Dies wiederum ermöglicht ein Bestimmen der elektrischen Energiemenge für ein Referenzstromprofil (etwa in dem Schritt 130) mit einem geringen Wert der Stromstärke.

Die Abweichungswerte der Abweichungen 16a-c sinken beispielsweise von der Abweichung 16a ausgehend über die Abweichung 16b hin zu der Abweichung 16c. Das bedeutet, es kann auf eine sinkende SEI-Bildung geschlossen werden. Dies wiederum ermöglicht das Bestimmen der elektrischen Energiemenge derart, dass das Referenzstromprofil eine Information darüber aufweist, dass in den Zeitintervallen 18a-c eine zunehmend hohe Energiemenge an die zu formierende Batterie geliefert werden soll.

In Bereichen, in denen die dU/dQ-Kurven (Verläufe 12 und 14) zumindest annähernd deckungsgleich sind (etwa gleich innerhalb eines Toleranzbereichs) kann auch eine Abweichung gering sein. Das Bestimmen der elektrischen Energiemenge kann für diesen Fall so ausgeführt werden, dass das Referenzstromprofil eine Information darüber aufweist, dass ein hoher oder maximaler Strom in den Zeitintervallen an die Batterie geliefert werden soll.

Eine Länge der Zeitintervalle 18a-d kann beliebig klein ausgeführt werden. Beispielsweise kann eine zeitliche Länge eines Zeitintervalls des Referenzstromprofils eine Zeitspanne beschreiben, in der der erste Verlauf 12 oder der zweite Verlauf 14 eine Änderung von höchstens 0,01 V, höchstens 0,05 V oder höchstens 0,21 V ausführt. Alternativ oder zusätzlich kann sich die Dauer eines Zeitintervalls 18a-d auch auf eine Zeitspanne beziehen oder mit dieser korrelieren, innerhalb der die Batterie eine elektrische Spannung aufweist, die innerhalb eines Toleranzbereichs von zumindest 0,01% und höchstens 30%, von zumindest 0,05% und höchstens 10% oder von zumindest 0,09% und höchstens 1%, bspw. mit etwa 0,1 % unverändert ist. Alternativ kann eine Länge der Zeitintervalle 18a-d auch basierend auf einer zeitlichen Dauer erhalten werden, etwa in einem Bereich zwischen 10 Sekunden und 3 Stunden, in einem Bereich zwischen 1 Minute und 1 Stunde oder in einem Bereich zwischen 5 Minuten und 30 Minuten. Insbesondere kann es vorteilhaft sein, während des Formierungsprozesses zumindest drei Anpassungen der elektrischen Energiemenge pro Stunde auszuführen.

Gegen Ende des ersten Ladevorgangs (Spannung bspw. größer als 4,1 V) sinkt der dU/dQ-Wert des ersten Verlaufs 12 bspw. wieder im Vergleich zu dem zweiten Ladevorgang (Abweichung 16d). In diesem Bereich kann das Referenzstromprofil eine Anweisung zur Bereitstellung einer reduzierten Stromstärke aufweisen. Für jedes Zeitintervall 18a-d kann aus den beiden Verläufen 12 und 14 eine Differenz (Abweichung) in Abhängigkeit der Spannung berechnet werden. Alternativ kann bspw. auch ein Quotient umfassend einem Wert des ersten Verlaufs 12 und einen Wert des zweiten Verlaufs 14 zur Bestimmung der Abweichung verwendet werden. Die Abweichung kann beispielsweise als D_{i(U)} bezeichnet werden. Diese kann mit einer festgelegten Umrechnungsfunktion (f) in ein Stromprofil bzw. Referenzstromprofil I_{i(U)} umgerechnet oder abgebildet werden, was beispielsweise durch I_{i(U)} = f (D_{i(U)}) darstellbar ist. Die Umrechnungsfunktion f kann beispielsweise so festgelegt werden, dass die Stromstärke zu Beginn (I_{Start}) einen Wert zwischen 1/50 C und 1/5 C, 1/30 C und 1/10 C, etwa 1/20 C (d. h., zwischen Iₙₑₙ/50 und Iₙₑₙ/10) entspricht. Diese Stromstärke kann beispielsweise linear, exponentiell oder mit einem anderen Zusammenhang bis zur Deckungsgleichheit mit einem vorgegebenen maximalen Wert, etwa 1 C (Iₙₑₙ) ansteigen. Die Umrechnungsfunktion ist beispielsweise darstellbar durch I_{i(U)} = Iₙₑₙ · (1-(D_{i(U)}/(D1/(1- I_{Start})))), wobei D1 einem Wert zumindest einer Abweichung entsprechen kann. Bei dem Wert D1 kann es sich um den Wert der größten Abweichung (etwa Abweichung 16a) handeln. Alternativ kann es sich um den jeweiligen Abweichungswert des Zeitintervalls oder um einen von zumindest einem Abweichungswert abgeleiteten Wert handeln). Neben der Spannung kann das Diagramm bzw. das komplette Referenzverfahren auch über eine Zeitachse (Iᵢ₍ₜ₎) oder absoluten Ladungs-(I_{i(Q)}) oder elektrischen Energieachse(I_{i(E)}) darstellbar sein und/oder Werte aufweisen, die entsprechend berechnet werden.

Während des Lade- oder Entladezyklus bzw. dem Formierungsprozess kann auch ein veränderliche Umrechnungsfunktion angewendet werden. Bspw. kann in einem ersten Spannungsbereich der Batterie (bspw. außerhalb des Arbeitsbereichs) eine erste Umrechnungsfunktion oder ein konstanter Strom mit einem konstanten Wert an die Batterie angelegt werden. In einem zweiten Spannungsbereich (etwa innerhalb des Arbeitsbereichs der Batterie) kann eine andere Umrechnungsfunktion einen bestimmten Wert des Stroms beeinflussen. Vereinfacht ausgedrückt kann die Umrechnungsfunktion über einen Lade- oder Entladevorgang veränderlich sein.

Eine Spannung, die an Polen der Batterie erhalten wird und sich während eines Lade- oder Entladezyklus ändern kann, eine Spannungsänderung (ggf. in Abhängigkeit einer an die Batterie geführten Ladungsmenge) und/oder eine Ladungsmenge, die an die Batterie geführt wird, können eine wechselseitige Beziehung zu einander aufweisen und zumindest mit einer hinreichenden Genauigkeit überführbar sein. Andere Verläufe, Abweichungen und/oder Referenzenergieprofile können sich somit auf eine Spannung, eine Spannungsänderung und/oder eine Ladungsmenge beziehen.

Vereinfacht ausgedrückt kann basierend auf der Abweichung für jedes der Zeitintervalle eine elektrische Energiemenge bestimmt werden. Die elektrische Energiemenge kann eine Sollvorgabe des Referenzstromprofils für eine Energiemenge beschreiben, die während eines Formierungsprozesses einer zu formierenden Batterie zuzuführen ist. Das Bestimmen der elektrischen Energiemenge kann basierend auf einer Umrechnungsfunktion mit zumindest einem Funktionsargument (Abweichung) erfolgen.

Alternativ zu Abweichungen 16a-d, die als Differenz beschrieben sind, kann das Bestimmen der Abweichung auch eine Quotientenbildung eines Wertes des ersten Verlaufs 12 und des zweiten Verlaufs 14 umfassen.

Das Referenzstromprofil kann beispielsweise für ein Zeitintervall eine konstante Stromstärke vorgeben. Das Zeitintervall kann so kurz ausgeführt sein, dass eine im Wesentlichen analoge und dynamische Änderung der Stromstärke erreicht wird.

Obwohl der erste Verlauf 12 und der zweite Verlauf 14 als Kurven dargestellt sind, kann es sich bei dem ersten Verlauf 12 und/oder dem zweiten Verlauf 14 um eine Vielzahl von Werten handeln, zwischen denen der jeweilige Verlauf interpoliert oder extrapoliert wird. Auch kann das Referenzstromprofil als ein Verlauf, ggf. darstellbar als Funktion, oder eine Vielzahl von Werten dargestellt werden.

In anderen Worten verdeutlicht das dU/dQ-Diagramm, wie stark sich die Spannung in einem kurzen Zeitintervall dt im Verhältnis zur eingebrachten oder entnommenen Ladung verändert hat. Somit kann dargestellt werden, wo mehr Ladung für eine Spannungsänderung benötigt wird. Wird beispielsweise der erste Formierzyklus (Verlauf 12) mit dem darauf folgenden zweiten Zyklus (Verlauf 14) verglichen, kann festgestellt werden, in welchem Bereich die erste Ladung bzw. der erste Ladevorgang mehr Ladung für die Spannungsänderung benötigt. Diese zusätzliche Ladung geht in Nebenreaktionen, hier vor allem der SEI-Bildung, zumindest teilweise verloren. Somit gibt die Differenz (Abweichung) beider Kurvenverläufe die Größenordnung der SEI-Bildung zumindest teilweise wieder. Damit kann zum einen ein optimales Formierstromprofil wie vorangehend beschrieben erstellt werden. Es kann eine Referenzformierung mit einem geringen konstanten Strom durchgeführt werden. Die Differenz zwischen den dU/dQ-Kurven zweier, gegebenenfalls aufeinanderfolgender Lade- und/oder Entladevorgänge kann anhand einer Formel (Umrechnungsfunktion) in ein Stromprofil umgerechnet werden.

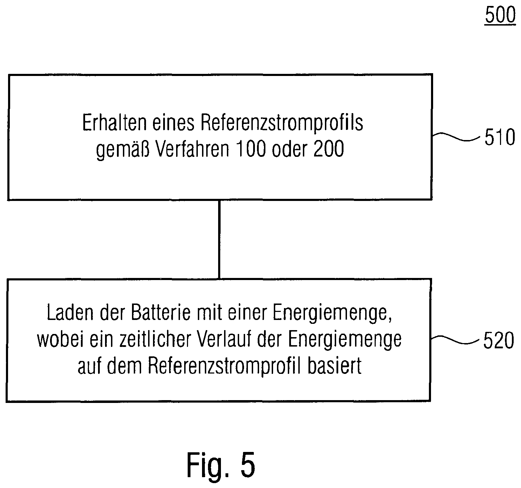

Fig. 5 zeigt ein schematisches Flussdiagramm eines Verfahrens 500 zum Formieren einer Batterie gemäß einem Ausführungsbeispiel. In einem Schritt 510 des Verfahrens 500 wird ein Referenzstromprofil gemäß Verfahren 100 oder gemäß Verfahren 200 erhalten. Das Erhalten kann beispielsweise mittels eines Speicherns des erhaltenen Referenzstromprofils und/oder einer Übermittlung derselben erfolgen.

In einem Schritt 520 des Verfahrens 500 wird die Batterie mit einer Energiemenge geladen. Ein zeitlicher Verlauf der Energiemenge basiert auf dem Referenzstromprofil. Vereinfacht ausgedrückt kann eine steuerbare Energiequelle so gesteuert werden, dass sie eine Energiemenge aufbauend auf oder gemäß dem Referenzstromprofil an die Batterie liefert.

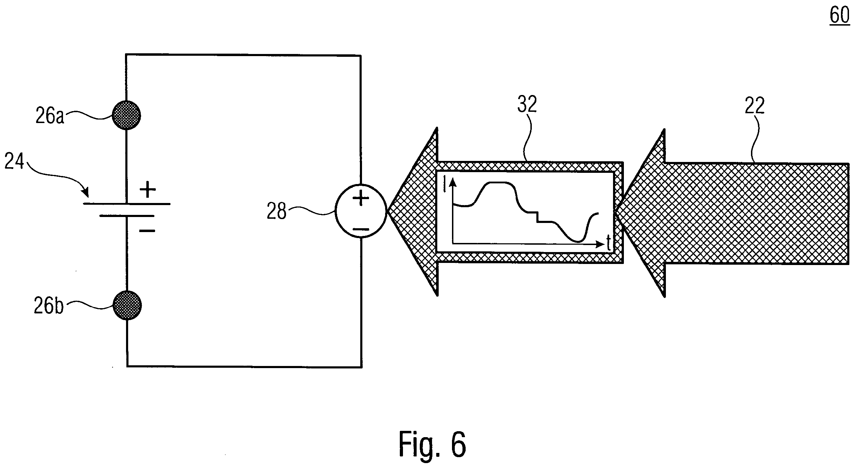

Fig. 6 zeigt ein schematisches Blockschaltbild einer Vorrichtung 60 zur Verwendung eines Referenzstromprofils 22 gemäß einem Ausführungsbeispiel. Das Referenzstromprofil 22 ist beispielsweise mit dem Verfahren 100 oder 200 erstellt. Eine mit einer Batterie 24 an Kontaktstellen 26a und 26b gekoppelte steuerbare Energiequelle 28 ist ausgebildet, um die elektrische Energie gemäß dem Referenzstromprofil an die Batterie 24 zu liefern. Beispielsweise kann das Referenzstromprofil 22 in einem Speicher einer Steuervorrichtung 32 gespeichert sein. Alternativ können auch mehrere Referenzstromprofile in dem Speicher 22 gespeichert sein, um eine Widerholte Ausführung der Formierung mit einem jeweils angepassten Referenzstromprofil zu ermöglichen. Das Referenzstromprofil ist mit einem Verlauf eines Stroms I über die Zeit t dargestellt. Wie vorangehend beschrieben, kann die Zeit t aber auch als eine Anzahl von Intervallen verstanden werden oder in dem Referenzstromprofil beschrieben sein, während dem die Batterie 24 einen bestimmten oder innerhalb eines Toleranzbereichs unveränderten physikalischen Zustand aufweist, etwa eine Spannung zwischen den Batteriepolen oder Kontaktstellen 26a und 26b, wie es im Zusammenhang mit Fig. 4 beschrieben ist.

Weist beispielsweise die Batterie 24 eine gleiche oder vergleichbare Eigenschaft auf, wie die Batterie(n), deren Verläufe oder deren Verlauf für die Bestimmung des Referenzstromprofils verwendet wurden, ermöglicht die Verwendung des Referenzstromprofils eine effiziente, d.h. schnelle und/oder mit einer hohen Qualität erhaltene Bildung der SEI.

Bei der steuerbaren Energiequelle kann es sich beispielsweise um eine steuerbare Stromquelle oder eine steuerbare Spannungsquelle handeln. Insbesondere kann es sich um eine steuerbare Gleichstromquelle handeln. Das Referenzstromprofil kann bspw. in Abhängigkeit von einer Stromstärke, einer Spannungsstärke oder der bereits zugeführten Ladungs- oder Energiemenge erstellt werden.

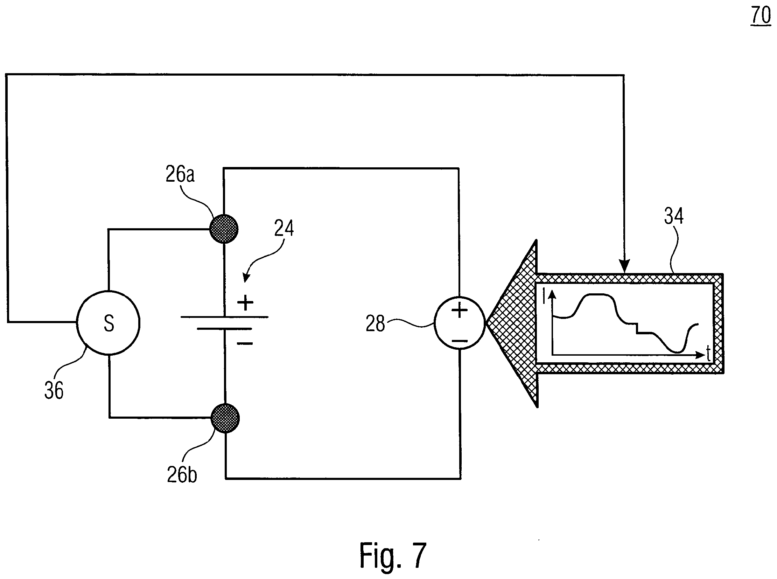

Fig. 7 zeigt ein schematisches Blockschaltbild einer Vorrichtung 70 zum Formieren der Batterie 24 gemäß einem Ausführungsbeispiel. Die Vorrichtung 70 umfasst die steuerbare Energiequelle 28 und eine Steuereinrichtung 34. Die Steuereinrichtung 34 ist ausgebildet, um die steuerbare Energiequelle 28 in der Vielzahl von Zeitintervallen zu steuern. Die Steuereinrichtung 34 kann ausgebildet sein, um die steuerbare Energiequelle 28 so zu steuern, dass eine Stromstärke, eine Frequenz eines oder mehrerer Strompulse oder dergleichen dynamisch verändert ist. Die Vorrichtung 70 umfasst eine Erfassungseinrichtung 36, die ausgebildet ist, um einen physikalischen Zustand der Batterie 24 in zumindest einem, mehreren oder jedem der Zeitintervalle zu bestimmen. Die Steuereinrichtung 34 ist ausgebildet, um basierend auf dem erfassten physikalischen Zustand die elektrische Energiequelle 28 so zu steuern, dass eine Menge an elektrischer Energie, die während des restlichen laufenden oder eines folgenden Zeitintervalls an die Batterie 24 geliefert wird, erhöht oder gesenkt wird.

Der physikalische Zustand kann sich beispielsweise auf eine elektrische Spannung, die an Batteriepolen der Batterie anliegt, auf eine elektrische Stromstärke, die an die Batterie 24 geführt wird, eine elektrische Ladungsmenge, die von der Batterie aufgenommen wird, eine Zeitdauer, in der eine elektrische Energie von der Batterie aufgenommen wird, auf eine Temperatur, die an oder in der Batterie anliegt und/oder auf hiervon abgeleitete Werte beziehen. Insbesondere kann sich der physikalische Zustand auf den im Zusammenhang mit Fig. 4 beschriebenen Spannungsgradienten beziehen. Erfindungsgemäß bezieht sich der physikalische Zustand auf eine Spannungsänderung der an Batteriepolen der Batterie anliegenden elektrischen Spannung im Verhältnis zu einer von der Batterie aufgenommenen Ladungsmenge (dU/dQ).

Vereinfacht ausgedrückt können Werte eines Referenzstromprofil zumindest teilweise während der Formierung der Batterie 24 basierend auf dem erfassten physikalischen Zustand und/oder basierend auf einem erfassten Verlauf bestimmt werden. Für jedes der Zeitintervalle kann die Steuereinrichtung 34 die steuerbare Energiequelle 28 so steuern, dass ein Maß der bereitgestellten elektrischen Energie unverändert, erhöht oder abgesenkt wird. Beispielsweise kann auch basierend auf einer bestimmten Erwärmung der Batterie 24 eine Ladungsmenge reduziert werden, um eine Überhitzung zu vermeiden.

Zusätzlich kann die Steuereinrichtung 34 ausgebildet sein, um einen Messwert des physikalischen Zustands, beispielsweise ein Wert, der von der Erfassungseinrichtung 36 bereitgestellt oder hieraus abgeleitet wird, einer Energiegröße zuzuordnen. Die Steuereinrichtung 34 kann ferner ausgebildet sein, um die steuerbare Energiequelle 28 so zu steuern, dass die steuerbare Energiequelle die bestimmte Energiegröße der Batterie innerhalb eines folgenden Zeitintervalls, d.h. einer Zeitdauer, die auf die Bestimmung folgt, bereitstellt. Insbesondere können die Zeitintervalle so kurz sein (bspw. in etwa 1 Minute), dass die Anpassung der elektrischen Energiemenge im Wesentlichen einem dynamischen Gleichstromverfahren entspricht.

Beispielsweise kann einer bestimmten Temperatur der Batterie 24, einer bestimmten Spannung der Batterie 24 oder einer bestimmten Abweichung zwischen Verläufen die Energiegröße zugeordnet sein. Beispielsweise kann die Steuereinrichtung 34 ausgebildet sein, um eine Umrechnungsfunktion auf den physikalischen Zustand (Funktionsargument) anzuwenden, um die Energiegröße (Funktionswert) zu erhalten.

In einer nicht erfindungsgemäßen Ausführungsform kann die Berechnung des dU/dQ-Wertes auch direkt beim Formieren der betroffenen Zelle stattfinden, anstatt das Stromprofil vorab festzulegen. Dies kann mit dem zweiten Zyklus, etwa dem Verlauf 14, aus der Referenzformierung verglichen und die Differenz in den neuen Formierstrom umgerechnet werden. Dies ermöglicht eine erhöhte Rücksichtnahme auf den tatsächlichen Zustand der Zelle. Eine dU/dQ-Referenz kann auch mittels eines Modells und/oder einer Simulation erstellt werden.

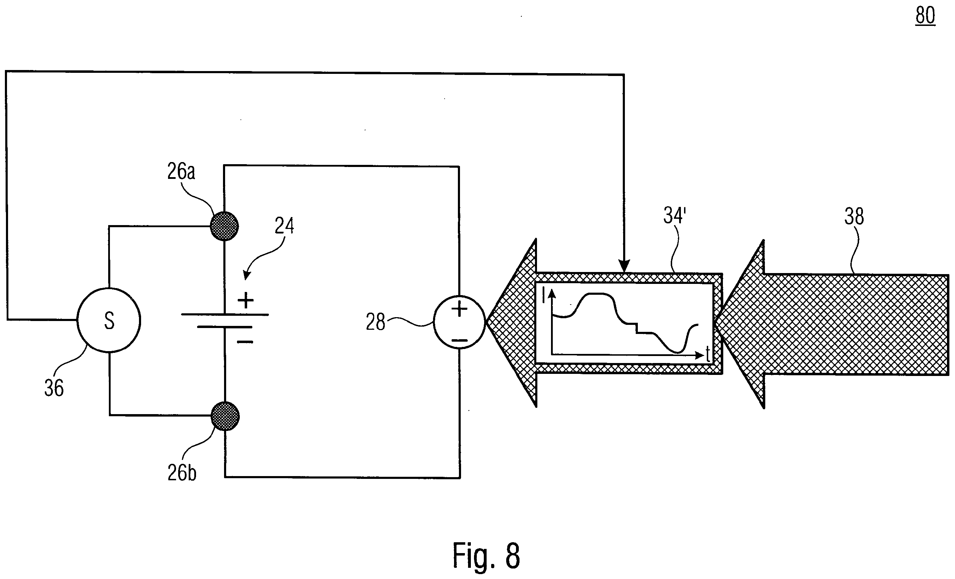

Fig. 8 zeigt ein erfindungsgemäßes schematisches Blockschaltbild einer Vorrichtung 80, die gegenüber der Vorrichtung 70 ferner einen Speicher 38 aufweist, der ausgebildet ist, um ein Referenzstromprofil und eine Sollwertvorgabe eines physikalischen Zustands zu speichern. Das Referenzstromprofil weist Sollwertvorgaben für die der Batterie bereitzustellenden elektrischen Energie und den physikalischen Zustand für zumindest eines der Vielzahl von Zeitintervallen des Ladezyklus auf. Eine Steuereinrichtung 34' ist ausgebildet, um die steuerbare Energiequelle 28 basierend auf dem in dem Speicher 38 hinterlegten Referenzstromprofil zu steuern.

Basierend auf einer Abweichung des in dem Referenzstromprofil 38 hinterlegten Referenzwerts für den physikalischen Zustand und dem von der Erfassungseinrichtung 36 bestimmten physikalischen Zustand ist die Steuereinrichtung 34' ausgebildet, um für zumindest eines, mehrere oder jedes der Zeitintervalle eine Abweichung zwischen dem physikalischen Zustand und der Sollwertvorgabe des physikalischen Zustands zu bestimmen. Zusätzlich kann in dem Speicher 38 bspw. der vorab bestimmte Verlauf 14 hinterlegt sein. In einer nicht erfindungsgemäßen Ausführungsform ermöglicht eine Erfassung der Spannung der Batterie 24 und eine Berücksichtigung der der Batterie 24 bereitgestellten Ladungsmenge den Erhalt des Verlaufs 12 im laufenden Betrieb (online), so dass eine Bestimmung von Werten des Referenzstromprofils und/oder eine Bestimmung von Werten der Sollwertvorgabe der bereitzustellenden Energiemenge im laufenden Betrieb erfolgen kann. Das bedeutet, dass zumindest einer der Verläufe 12 oder 14 auch gerade in Entstehung sein kann. Dies ermöglicht die Bestimmung der Energiemenge mit einer hohen Präzision, da der aktuelle Zustand der Batterie 24 für die Bestimmung berücksichtigt werden kann.

Die Steuereinrichtung 34' ist ferner ausgebildet, um die steuerbare Energiequelle 28 abweichend von der Sollwertvorgabe des Referenzstromprofils so zu steuern, dass die Batterie 24 mit einem geringeren oder höheren Maß an elektrischer Energie geladen oder entladen wird, wenn die Abweichung zwischen der Sollwertvorgabe des physikalischen Zustands und dem erfassten physikalischen Zustand größer ist als beispielsweise 3%, größer als 5 % oder größer als 10 %.

Alternativ können auch mehrere Referenzstromprofile in dem Speicher 38 gespeichert sein, um eine Widerholte Ausführung der Formierung mit einem jeweils angepassten Referenzstromprofil zu ermöglichen.

Ein Aspekt hierin beschriebener Ausführungsbeispiele liegt in der Möglichkeit, die Formierung der zu formierenden Batterie zu beschleunigen, indem die Menge an elektrischer Energie (Stromstärke) während zumindest einem Zeitintervall gegenüber den Verläufen 12 oder 14 einer Formierung mit einer konstanten Stromstärke erhöht ist. Während die in Fig. 4 dargestellten Verläufe 12 und 14 basierend auf der niedrigen Stromstärke einen geringen oder vernachlässigbaren Fehler zwischen einer Leerlaufspannung und der tatsächlichen Spannung an den Batterie aufweisen können, kann die Erhöhung der Stromstärke bei manchen Batterien dazu führen, dass eine an den Batteriepolen anliegende Spannung während der Formierung von einer Leerlaufspannung abweicht. Als Leerlaufspannung wird in diesem Zusammenhang eine Batteriespannung in einem lastfreien Zustand derselben verstanden und kann deshalb auch als lastfreie Spannung verstanden werden. Hierfür kann neben dem Wegfall der ohm'scher Effekte auch ein Abklingen der Kondensatorwirkungen und/oder Diffusionseffekte abgewartet werden, wobei Letzteres optional ist. Mit zunehmender Stromstärke oder einer zunehmenden Erhöhung des Stroms gegenüber einem Referenzenergieprofil oder einer konstanten Stromstärke in Übereinstimmung mit der Fig. 4 kann ein Abweichung zunehmend stärker sein. So kann die anliegende Spannung bei einer zunehmenden Ladung der zu formierenden Batterie höher sein, als die Leerlaufspannung oder bei einer zunehmenden Entladung der zu formierenden Batterie niedriger sein als die Leerlaufspannung. Unter Leerlaufspannung kann ein Zustand der Batterie verstanden werden, in welchem keine Last oder Energiequelle mit den Polen der Batterie verbunden ist.

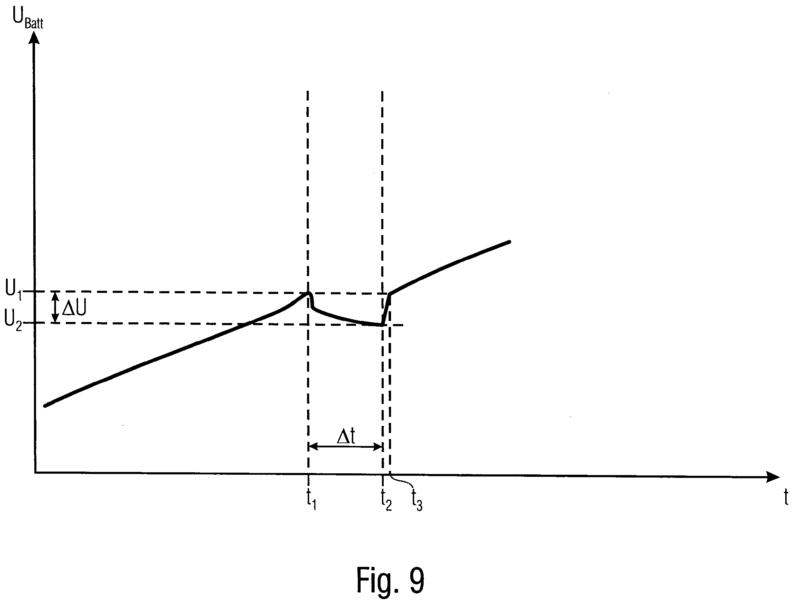

Gemäß einem Ausführungsbeispiel ist die Steuereinrichtung 32, 34 und/oder 34' der in den Fig. 6-8 beschriebenen Vorrichtungen ausgebildet, um eine Korrektur des Referenzenergieprofils vorzunehmen, wie es anhand der Fig. 9 beschrieben wird, die beispielhaft eine Korrektur während eines Ladevorgangs darstellt, jedoch ohne Einschränkungen auf einen Entladevorgang übertragbar ist.

Fig. 9 zeigt ein schematisches Diagramm mit einem Verlauf einer Batteriespannung während eines Formierungsprozesses, wie es gemäß einem Aspekt hierin beschriebener Ausführungsbeispiele erhalten werden kann.

Die Steuervorrichtung kann ausgebildet sein, um die ladende oder entladende Stromzufuhr an die Batterie zu einem Zeitpunkt t₁ zu unterbrechen. Die Steuervorrichtung ist ausgebildet, um eine physikalische Größe, etwa die potentiell fehlerhafte Spannung an den Batteriepolen U_{Batt} zu erfassen. Hierfür kann die Steuervorrichtung ausgebildet sein, um zum Zeitpunkt t₁ oder kurz vor dem Zeitpunkt t₁ die physikalische Größe (Spannung) zu erfassen. Die Spannung weist bspw. einen Wert U₁ auf. Vorzugsweise erfasst die Steuervorrichtung die Spannung U_{Batt} kurz, d. h. höchstens einige Sekunden oder Minuten, vor oder zum Zeitpunkt der Unterbrechung. Alternativ können über entsprechende Umrechnungsgrößen auch andere physikalische Größen, etwa Ladungsträgermengen, Stromstärken oder dergleichen erfasst werden.

Anschließend ist die Steuervorrichtung konfiguriert, um die Energiezufuhr oder Energieentnahme für ein Zeitintervall Δt unterbrochen zu halten, was eine Veränderung der Spannung U_{Batt} von dem Wert U₁ hin zu dem Wert U₂ ermöglicht. U₂ kann als Leerlaufspannung bezeichnet werden, wobei eine Länge des Intervalls Δt einen Wert von U₂ beeinflussen kann, was später beschrieben wird.

Die Steuervorrichtung kann ausgebildet sein, um zu einem Zeitpunkt t₂, der auf den Zeitpunkt t₁ folgt, die den Wert U₂ aufweisende Spannung U_{Batt} erneut zu erfassen, so dass die Steuervorrichtung über einen Wert der Leerlaufspannung Kenntnis hat. Die Steuervorrichtung kann ausgebildet sein, um die Leerlaufspannung U₂ mit dem Referenzenergieprofil zu vergleichen und um eine Abweichung ΔU zwischen der gemessenen Spannung U₁, welche für die Bestimmung der angelegten Stromstärke herangezogen werden kann, und der tatsächlichen Leerlaufspannung U₂ zu bestimmen.

Die Steuervorrichtung kann ausgebildet sein, um die Energiequelle zu einem Zeitpunkt t₂ wieder mit der Batterie zu verbinden, so dass der Entladevorgang oder Ladevorgang weitergeführt wird. Die Steuervorrichtung kann ausgebildet sein, um das Referenzenergieprofil durch die bestimmte Abweichung ΔU zu korrigieren. Dies kann so erfolgen, dass bei der Bestimmung der anzulegenden Stromstärke der physikalische Zustand Batteriespannung U_{Batt} um die Abweichung ΔU korrigiert wird und die anzulegende Stromstärke basierend auf dem korrigierten physikalischen Zustand (U_{Batt} - ΔU) ausgewählt wird. Wie es aus Fig. 9 hervorgeht, kann zu einem Zeitpunkt t₃, der auf den Zeitpunkt t₂ folgt, die Batteriespannung U_{Batt} wieder durch die Energiezufuhr oder -abfuhr verfälscht sein, was durch die Korrektur zumindest teilweise kompensierbar ist, sodass eine Effizienz und Genauigkeit des Formierungsprozesses trotz der Wartezeit Δt erhöht ist.

Bei der Wartezeit Δt kann es sich um ein beliebiges Zeitintervall handeln. Vorzugsweise liegt ein Wert einer Dauer des Zeitintervalls in einem Bereich zwischen 0,1 s und 600 s. Die Dauer kann abhängig von zumindest einem physikalischen Effekt in der Batterie gewählt werden, der berücksichtigt werden soll. So kann bspw. durch eine zeitliche Dauer Δt in einem Bereich von zumindest 0,1 s und höchstens 1 s hauptsächlich ohm'sche Effekte in der Batterie berücksichtigen. Längere Zeitdauern Δt von mehr als 1 s und höchstens 600 s können zusätzlich Kondensatorwirkungen und/oder Diffusionseffekte in der Batterie berücksichtigen.

Gemäß einer vorteilhaften Weiterbildung ist die Steuervorrichtung ausgebildet, um die Korrektur basierend auf einer Hilfsgröße, etwa einem Innenwiderstand der Batterie 24 auszuführen. Hierfür kann die Steuervorrichtung ausgebildet sein, basierend auf den Spannungswerten U₁, U₂ und auf der Energiemenge, die vor der Unterbrechung an die Batterie geführt wurde, unter Nutzung der ohm'schen Gesetzte die Hilfsgröße für die Batterie zu berechnen. Nachfolgende Ausführungen beziehen sich auf eine Berechnung der Hilfsgröße als Innenwiderstand der Batterie. Es wird jedoch darauf hingewiesen, dass jede andere Größe verwendbar ist, die eine Verknüpfung der Spannungswerte U₁, U₂ und der Energiemenge umfasst, etwa einen Leitwert oder andere - nicht physikalisch gebräuchliche - mathematische Größen.

Die Steuervorrichtung kann ausgebildet sein, um den Innenwiederstand unter Nutzung der bestimmten Abweichung ΔU zu bestimmen und/oder um den Innenwiderstand mit einem Referenzinnenwiderstand zu vergleichen. Das Bestimmen des Innenwiderstands kann unter Nutzung der ohm'schen Gesetzte ausgeführt werden. Der Innenwiderstand verändert sich mit der zunehmenden Bildung der SEI an der Batterie. Wie es im Zusammenhang mit der Fig. 4 erläutert ist, können Zeitintervalle existieren, in denen sich die Spannung an der Batterie durch den Lade- oder Entladevorgang relativ stark ändert und gleichzeitig wenig SEI gebildet wird, d. h. es wird ein geringer Anteil zugeführter Energie in SEI-Bildung und ein hoher Anteil in die Ladung der Batterie umgesetzt. In diesen Abschnitten verändert sich somit die Leerlaufspannung in einem höheren Umfang, während sich der Innenwiderstand geringfügig ändert. Eine Nutzung des Innenwiderstands für die Korrekturzwecke erlaubt somit eine weitere Steigerung der Präzision des Vorgangs, da er einen Aufschluss über den tatsächlichen Zustand der Batterie liefert.

Der bestimmte Innenwiderstand kann unter einer Berücksichtigung des Stroms, der nach der Unterbrechung an die Batterie geführt wird, in einen Spannungswert überführt werden, um welchen das Referenzenergieprofil korrigiert wird. Ist der Strom unverändert gegenüber einem Wert vor der Unterbrechung, so kann das Ergebnis ΔU lauten. Wird jedoch ein veränderter Strom angelegt, so kann eine veränderte Spannungsdifferenz ΔU' als Korrekturwert erhalten werden. Der bestimmte Spannungswert kann einen Offsetwert bilden, um welchen das Referenzenergieprofil korrigiert wird, was auch als Verschiebung des Referenzenergieprofils um den Offsetwert auf der x-Achse eines Diagramms analog Fig. 4, d. h. anzulegender Strom über Spannung an den Batteriepolen, verstanden werden kann.

Der Vorteil der Hilfsgröße wird nun anhand einer theoretischen Betrachtung verdeutlicht. Würde nach der Unterbrechung ein höherer oder niedrigerer Strom an die Batterie angelegt als vor der Unterbrechung der Energiezufuhr, so wäre bei einer reinen Verwendung der Spannungsdifferenz ΔU für die Korrektur bereits ein zusätzlicher Fehler anwesend, der in der zuvor ausgeführten Korrekturwertbestimmung nicht berücksichtigt ist. Wird jedoch die Hilfsgröße verwendet, so lässt sich der neue, veränderte Strom mit der Hilfsgröße kombinieren und eine andere Spannungsdifferenz als die zuvor als Ergebnis erhalten. Diese andere Spannungsdifferenz kann als Korrekturwert oder Offsetwert verwendet werden und berücksichtigt gleichzeitig die Veränderung der zugeführten Energiemenge.

Der Referenzinnenwiderstand kann bspw. auch während des ersten Verlaufs 12 und/oder zweiten Verlaufs 14 erfasst und für die Steuervorrichtung hinterlegt werden. Die Steuervorrichtung kann ausgebildet sein, um das Referenzenergieprofil basierend auf dem bestimmten Innenwiderstand oder einem Vergleich desselben mit einem Referenzinnenwiderstand zu korrigieren.

Eine Korrektur unter Verwendung der Leerlaufspannung kann eine hinreichende Genauigkeit bieten, insbesondere solange keine erneute Anpassung des Stroms erfolgt. Bei einer erneute Anpassung kann die bestimmte Abweichung zwischen den Spannungen U₁ und U₂ jedoch von einem tatsächlichen Zustand der Batterie abweichen, da eine Stromanpassung auch zu einer Veränderung der Abweichung zwischen der tatsächlichen Spannung U₁ und der Leerlaufspannung U₂ führen kann. Das bedeutet, ein erneutes Erhöhen des Stroms kann zu einem zusätzlichen Fehler führen, der zu diesem Zeitpunkt noch unbestimmt ist, d. h., das bestimmte ΔU ist ggf. inkorrekt. Dies könnte durch eine Fehlerbestimmung oder Korrektur zu jedem Zeitpunkt, zu dem eine Stromanpassung erfolgt, behoben werden. Alternativ kann vorteilhaft eine Verwendung des Innenwiderstands erfolgen, denn der Innenwiderstand wird nicht oder in geringem Umfang von einer Stromanpassung beeinflusst. Der bestimmte Innenwiderstand kann somit auch für zukünftige Anpassungen verwendet werden, so dass eine Anzahl von Unterbrechungen zur Bestimmung des Innenwiederstands und mithin ein Zeitverlust durch die Korrektur gering ist.

Die beschriebene Korrektur kann auch in einem Online-Verfahren, wie es im Zusammenhang mit der Fig. 8 beschreiben ist, angewendet werden. Dort kann die Menge an elektrischer Energie während des Betriebs ermittelt werden. Diese Menge an elektrischer Energie kann dann durch Anwenden des Korrekturverfahrens korrigiert werden, so dass bereits ein korrigierter Wert angelegt wird.

Eine Häufigkeit der Messungen der Leerlaufspannung und/oder der Bestimmung des Innenwiderstandes kann in einer beliebigen Häufigkeit erfolgen und bspw. mit Häufigkeit entsprechen, in der die Abweichungen 16a-a bestimmt werden. Alternativ kann auch nur für einige der Zeitintervalle eine Messung der Leerlaufspannung und/oder eine Bestimmung des Innenwiderstandes erfolgen oder es kann eine Messung der Leerlaufspannung und/oder eine Bestimmung des Innenwiderstandes unabhängig von den Zeitintervallen erfolgen.

Die bestimmte Abweichung zwischen der tatsächlichen Leerlaufspannung U₂ und der angenommenen Quasi-Leerlaufspannung des ersten oder zweiten Verlaufs kann als Offsetwert in einem Speicher der Steuervorrichtung hinterlegt werden und bis zu einer erneuten Messung für die Korrekturzwecke berücksichtigt werden. Alternativ oder zusätzlich kann die bestimmte Abweichung zwischen dem tatsächlichen Innenwiderstand und dem angenommenen Quasi-Innenwiderstand des ersten oder zweiten Verlaufs als Offsetwert in dem Speicher der Steuervorrichtung hinterlegt werden und bis zu einer erneuten Messung für die Korrekturzwecke berücksichtigt werden.

Zusammengefasst kann ein Verfahren zum Korrigieren eines Referenzenergieprofils folgende Schritte aufweisen: Es kann ein Laden oder Entladen einer zu formierenden Batterie mit einem Referenzenergieprofil erfolgen, das eine Information über eine an die Batterie zu liefernde elektrische Größe aufweist, etwa einen Strom. Ferner kann ein Bestimmen einer ersten physikalischen Größe der Batterie zu einem ersten Zeitpunkt t₁ erfolgen. Es kann ein Unterbrechen des Ladens oder Entladens der Batterie durchgeführt werden und ein Bestimmen der ersten physikalischen Größe der Batterie zu einem zweiten Zeitpunkt t₂, der auf den ersten Zeitpunkt t₁ folgt, ausgeführt werden. Das Verfahren kann ein Bestimmen einer Abweichung zwischen der ersten physikalischen Größe zum ersten Zeitpunkt und der ersten physikalischen Größe zum zweiten Zeitpunkt, ein Korrigieren des Referenzenergieprofils basierend auf der bestimmten Abweichung eine Wiederaufnahme des Ladens oder Entladens umfassen.

Vorteilhafte Weiterbildungen des Verfahrens können so ausgestaltet sein, dass das Referenzenergieprofil die Information über die an die Batterie zu liefernde elektrische Größe in Abhängigkeit einer an Batteriepolen der Batterie anliegenden elektrischen Spannung aufweist, dass der erste physikalische Zustand die an Batteriepolen der Batterie anliegende elektrische Spannung ist und dass das Korrigieren des Referenzenergieprofils basierend auf der bestimmten Abweichung erfolgt.

Andere vorteilhafte Weiterbildungen des Verfahrens können so ausgestaltet sein, dass eine Hilfsgröße für die Batterie basierend auf der Abweichung und basierend auf der vor dem Unterbrechen mit einem ersten Wert an die Batterie gelieferte elektrische Größe (Strom) bestimmt wird. Es kann ein Korrekturwert für das Referenzenergieprofil basierend auf der Hilfsgröße und basierend auf einem zweiten Wert der an die Batterie gelieferten elektrische Größe, der nach dem Wiederaufnehmen angewendet wird, bestimmt werden. Dieser kann vom ersten Wert verschieden oder gleich sein. Das Referenzenergieprofil kann basierend auf dem bestimmten Korrekturwert korrigiert werden. Diese Korrektur kann von Vorrichtungen hierin beschriebener Ausführungsbeispiele unabhängig oder in Kombination mit anderen Verfahren ausgeführt werden.

Alternativ oder zusätzlich können die vorteilhaften Ausgestaltungen so ausgeführt sein, dass es sich bei der ersten physikalischen Größe der Batterie 24 zu dem zweiten Zeitpunkt t₂ um eine Leerlaufspannung U₂ der Batterie 24 handelt.

Vereinfacht ausgedrückt kann das gegenüber dem ersten oder zweiten Verlauf beschleunigte Laden oder Entladen zu einer Abweichung der an den Batteriepolen anliegenden Spannung gegenüber der Leerlaufspannung des ersten oder zweiten Verlaufs führen, so dass eine Ungenauigkeit während der Formierung auftritt, wenn die Spannung an den Batteriepolen mit der Leerlaufspannung gleichgesetzt wird. Diese Ungenauigkeit kann durch Heranziehen der tatsächlichen Leerlaufspannung reduziert werden und kann weiter reduziert werden, wenn der Innenwiderstand als Korrekturparameter herangezogen wird.

In anderen Worten kann die Steuereinrichtung in 32, 34 und/oder 34' ferner so ausgebildet sein, dass sie den aktuellen Innenwiderstand der angeschlossenen Zelle ermitteln kann und das Referenzstromprofil bzw. Referenzenergieprofil dementsprechend anpassen kann. Hierfür unterbricht die Steuereinrichtung für eine kurze Zeit (0,1 bis 600 Sekunden) die Energiezuführung bzw. Energieentnahme (alternativ Stromzuführung / Stromentnahme, alternativ den Ladevorgang / Entladevorgang). Dadurch ergibt sich eine Spannungsantwort (dUₜ), die gemessen werden kann (dUₜ = U_{direkt vor Unterbrechung} - U_{t Sekunden nach Unterbrechung}). Mit dieser Spannungsantwort lässt sich dann mit bekannten Rechenvorschriften der Innenwiderstand berechnen (Rₜ = dUₜ / I_{kurz vor Unterbrechung}). Mit dem Innenwiderstand kann das Referenzstromprofil so abgeändert werden, dass es beispielsweise um einen Betrag auf der x-Achse (siehe Fig. 4) verschoben wird, welcher sich aus dem aktuellen Strom und dem gemessenen Innenwiderstand durch Anwendung der ohm'schen Gesetzte errechnet, das Referenzprofil also hinsichtlich der Auswirkungen des sich ändernden Innenwiderstands korrigiert wird.

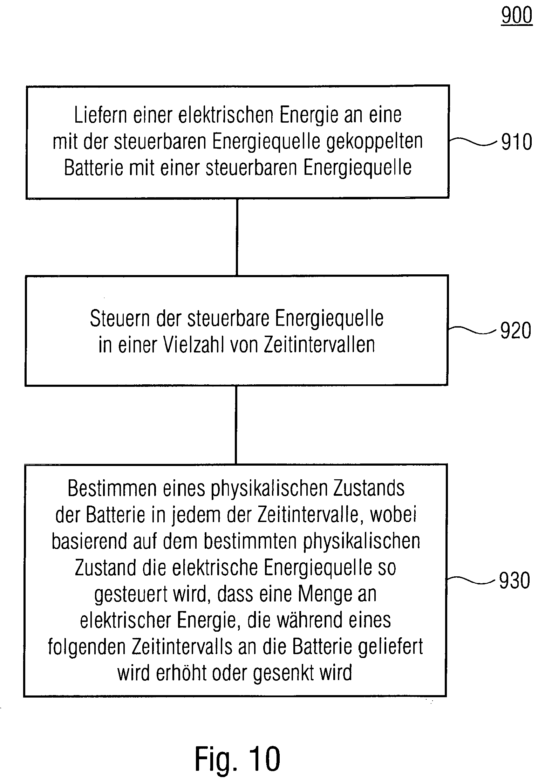

Fig. 10 zeigt ein schematisches Flussdiagramm eines Verfahres 900 zum Formieren einer Batterie. Das Verfahren 900 umfasst einen Schritt 910 in dem eine elektrische Energie an einen mit einer steuerbaren Energiequelle gekoppelten Batterie mit einer steuerbaren Energiequelle geliefert wird. In einem Schritt 920 wird die steuerbare Energiequelle in einer Vielzahl von Zeitintervallen gesteuert. In einem Schritt 930 wird ein physikalischer Zustand der Batterie in jedem der Zeitintervalle bestimmt, wobei basierend auf dem bestimmten physikalischen Zustand die elektrische Energiequelle so gesteuert wird, dass eine Menge an elektrischer Energie, die während eines folgenden Zeitintervalls an die Batterie geliefert wird, erhöht oder gesenkt wird.

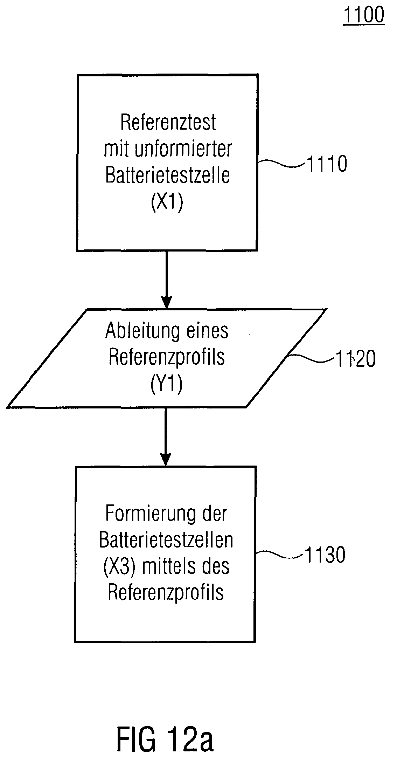

Nachfolgend beschriebene Fig. 12a-d erläutern schematisch die Anwendbarkeit vorangehend beschriebener Ausführungsbeispiele für die Erstellung eines Referenzenergieprofils und/oder dessen Anwendung. Insbesondere wird verdeutlicht, wie die hierin beschriebenen Ausführungsbeispiele auf Grundlage eines Vergleichs einer regulär oder normal formierten Batterie oder Batteriezelle mit einer unformierten oder zu formierenden Batterie, deren SEI noch nicht oder noch nicht ausreichend formiert, d.h. aufgebaut ist, erfolgt. Die normal formierte Batterie ist in den folgenden Figuren als X2 bezeichnet und kann als formierte Batterie bzw. Batteriezelle, deren SEI ausgebildet oder ausreichend ausgebildet ist, verstanden werden. Mit X1 und X3 sind jeweils Batterien, die noch nicht oder noch nicht ausreichend formiert sind, bezeichnet. Das nachfolgend beschriebene Ableiten eines Referenzprofils kann beispielsweise so verstanden werden, dass ein Vergleich zwischen zwei Zellen erfolgt, etwa der im Zusammenhang mit Fig. 4 beschriebene Vergleich zwischen Messwerten. Hierbei kann eine Differenz von Messwerten gebildet werden, die sich auf einen dU/dQ-Verlauf, d.h. eine Spannungsänderung in Relation gesetzt zu einer aufgenommenen Ladungsträgermenge, zwischen verschiedenen Lade- und/oder Entladevorgängen bezieht. Ein mit Y2 bezeichneter Verlauf kann sich auf ein Normalprofil der normal formierten Zelle X2 beziehen, der mit einem Verlauf Y1 einer unformierten Zelle X1 oder X3 verglichen wird. Alternativ kann ein Referenzenergieprofil bzw. Referenzprofil wie etwa ein Stromprofil für die Formierung der Batterie X3 errechnet werden oder anstatt einer initialen Messung mittels einer Simulation erhalten werden, was als Y3 bezeichnet wird.

Fig. 12a zeigt ein schematisches Flussdiagramm eines Verfahrens 1100, bei dem in einem Schritt 1110 ein Referenztest mit einer unformierten Batterietestzelle, d. h. mit einer Batterie X1, durchgeführt wird. In einem Schritt 1120 wird ein Referenzprofil Y1 abgeleitet, etwa durch einen Vergleich der Messwerte, die in dem Schritt 1110 erhalten werden, mit einem Normalprofil Y2. In einem Schritt 1130 kann eine Formierung zumindest einer Batteriezelle X3 mittels des Referenzprofils erfolgen. Der Schritt 1110 kann beispielsweise den Schritt 110 und/oder den Schritt 210 umfassen. Der Schritt 1120 kann beispielsweise die Schritte 120, 130 und/oder 220 umfassen. Der Schritt 1130 kann das Verfahren 900 umfassen.

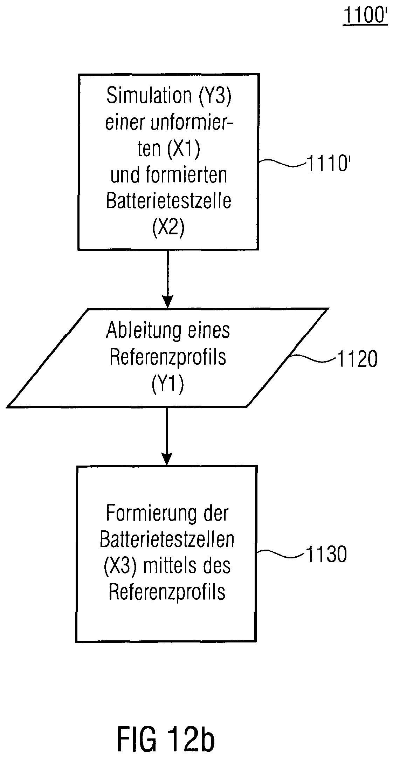

Fig. 12b zeigt ein schematisches Flussdiagramm eines gegenüber dem Verfahren 1100 modifizierten Verfahrens 1100'. Alternativ zu dem Schritt 110 weist das Verfahren 1100' einen Schritt 1110' auf, der alternativ oder zusätzlich zu dem Schritt 1110 durchgeführt werden kann. In dem Schritt 1110' erfolgt eine Simulation (Y3) einer unformierten oder lediglich teilweise formierten Batteriezelle X1 mit einer formierten Batterietestzelle X2. Wie es im Zusammenhang mit vorangehend beschriebenen Ausführungsbeispielen erläutert ist, kann somit anstelle eines Tests einer Batteriezelle auch eine entsprechende Simulation durchgeführt werden.

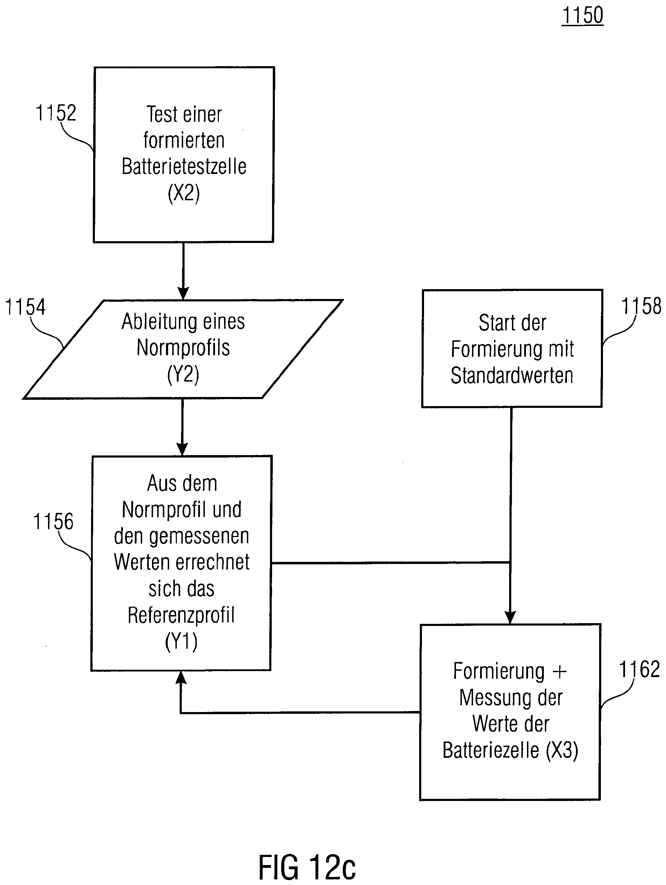

Fig. 12c zeigt ein schematisches Flussdiagramm eines nicht erfindungsgemäßen Verfahrens 1150, das einen Schritt 1152 aufweist, bei dem eine bereits formierte Batterietestzelle X2 untersucht wird. Hieraus kann in einem Schritt 1154 ein Normprofil Y2 abgeleitet werden, wie es bekannt ist. Aus dem in dem Schritt 1154 erhaltenen Normprofil und den gemessenen Werten kann ein Referenzprofil Y1 in einem Schritt 1156 erhalten werden, was in einer Art Regelkreis erfolgen kann. Hierfür kann beispielsweise in einem Schritt 1158 ein Start der Formierung mit Standardwerten, wie es beispielsweise durch das Normprofil vorgegeben ist, erfolgen. Basierend auf den Messwerten, die während der Formierung erfasst werden, wie es im Zusammenhang mit der Fig. 7 beschrieben ist. In einem Schritt 1162 ist die durch den Start 1158 erhaltene Formierung sowie die Messung der Werte der Batteriezelle X3, alternativ X1 dargestellt. Diese Messwerte werden in dem Schritt 1156 mit dem Normprofil Y2 verglichen. Das Normprofil Y2 wird basierend auf dem Vergleich angepasst, um das Referenzprofil Y1 zu erhalten. Das bedeutet, dass die Formierungskennwerte während der Formierung und im laufenden Betrieb angepasst werden können.

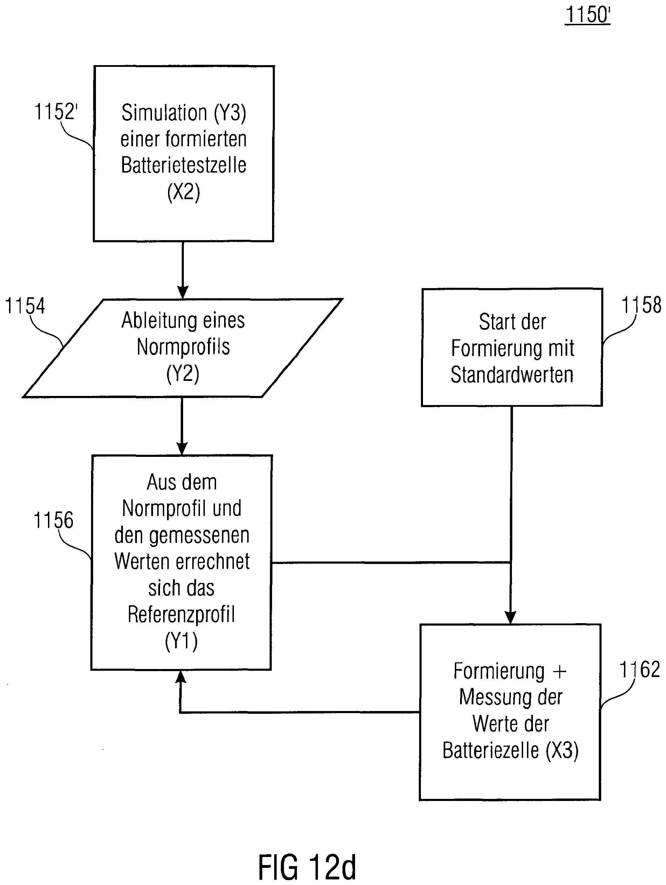

Fig. 12d zeigt ein schematisches Flussdiagramm eines nicht erfindungsgemäßen Verfahrens 1150' zur Formierung einer Batterie. Das Verfahren 1150' weist gegenüber dem Verfahren 1150 einen Schritt 1152' auf, der alternativ oder zusätzlich zu dem Schritt 1152 des Verfahrens 1150 ausführbar ist. In dem Schritt 1152' erfolgt eine Simulation Y3 einer formierten Batterietestzelle X2, das bedeutet, dass anstelle des Tests und/oder der Messung in dem Schritt 1152 eine Simulation der formierten Batterie erfolgen kann.

In anderen Worten kann die Stromstärke eine entscheidende Rolle bei der SEI-Bildung spielen. Die Stromstärke kann während verschiedener Stadien der Formierung einen unterschiedlich großen Einfluss haben. Zudem kann das elektrochemische Verhalten von Batteriezellen von vielen Faktoren, wie Zellchemie, Geometrie oder dergleichen abhängen. Gemäß vorangehend beschriebener Ausführungsbeispiele kann der elektrische Strom (Energiemenge) an die aktuelle Eigenschaft der Zelle angepasst werden, um ein Optimum an Prozessgeschwindigkeit und Produktqualität zu erzielen. Hierzu kann die Formierelektronik (Steuereinrichtung) den Strom so regeln, dass er einem zuvor für die Zelle definierten Profil (Referenzstromprofil) entspricht. Alternativ oder zusätzlich kann der Strom durch verschiedene gemessene Werte (physikalische Zustände) der jeweiligen Zelle angepasst werden. Dies ermöglicht eine Datenverarbeitung und eine hieraus abgeleitete neue Berechnung der Energiemenge für jeden Zeitabschnitt. Insbesondere können die Anwendung des Referenzstromprofils und die Verwendung der gemessenen Werte kombiniert werden.

Vorangehend beschriebene Ausführungsbeispiele können bei allen Batteriezellen angewendet werden, die während der ersten Lade- und Entladevorgänge eine SEI auf der Anoden- und/oder Katodengrenzschicht bilden. Insbesondere sind hier Lithium-Ionen-Zellen mit Graphit-/Kohlenstoff- oder Silizium-Anode aufgeführt.

Eine dynamische Anpassung des Stroms bzw. der elektrischen Energiemenge kann dazu führen, dass die Stromstärke zu jederzeit das Optimum für die Zelle darstellt.

Vorangehend beschriebene Ausführungsbeispiele beziehen sich auf eine zu ladende Batteriezelle, die über eine Kontaktierung mit einer (Gleich-)Stromquelle elektrisch verbunden ist. Die Formierung kann mittels eines dynamischen Stroms erfolgen. Die elektrische Stromstärke kann dynamisch zu jedem Zeitpunkt der Betrachtung steigen oder sinken. Die Stromstärke kann entweder durch ein vordefiniertes Profil definiert werden. Dieses Profil kann von vorneherein durch eine Referenzmessung bzw. eine Referenzformierung ermittelt oder anhand eines Modells durch eine Simulation ermittelt werden. Das Referenzstromprofil kann die Stromstärke für eine bestimmte Zeit oder eine bestimmte Spannung der Batterie festlegen, wobei zudem die Anzahl der Zyklen und die Richtung des Stroms eine Rolle spielen können. Das Referenzstromprofil kann sich alternativ oder zusätzlich auch auf eine Entladung der Batterie mit einer festgelegten Stromstärke beziehen. Vereinfacht ausgedrückt kann ein Entladevorgang als Umkehr der Stromrichtung beschrieben werden, so dass die oben aufgeführten Mechanismen ohne relevante Einschränkung wirksam bleiben.

Alternativ kann der Strom anhand eines durch einen oder mehrere Sensoren (Erfassungseinrichtung) gemessene Signale oder Werte berechnet werden. Von Bedeutung können hier die Spannung, Zeit, Stromstärke, Temperatur und/oder davon abgeleitete Größen wie die elektrische Ladung sein. Zudem kann auch ein System umgesetzt werden, das sich aus beiden Verfahren zusammensetzt, wie etwa die Vorrichtung 80. Beispielsweise wird ein Profil vorgegeben, das aufgrund gemessener Werte überarbeitet und/oder abgewandelt wird.

Vorausgehend beschriebene Ausführungsbeispiele ermöglichen eine deutliche Beschleunigung des Formierprozesses bei gleichbleibender oder sogar verbesserter Zyklenfestigkeit der Batteriezelle. Durch die Verkürzung des Vorgangs entsteht ein zeitlicher und mithin wirtschaftlicher Vorteil. Außerdem kann durch vorangehend beschriebene Ausführungsbeispiele eine hohe Qualität (Qualitätsverbesserung) der gebildeten SEI erzielt werden.

Vorangehend beschriebene Ausführungsbeispiele können zu einer deutlichen Verkürzung der Formierung führen, was zu einem hohen Produktionsdurchsatz von Formierungsanlagen oder -Vorrichtungen führen kann.

Vorangehend beschriebene Ausführungsbeispiele können bei der Herstellung von Batteriezellen, insbesondere von Lithium-Ionen-Zellen, aber auch bei anderen Batteriezellen umfassend andere Zellchemien, die eine SEI-Bildung aufweisen, angewendet werden. Beispielsweise können dies Zellen mit Silizium als Anodenmaterial anstelle eines Graphitmaterials sein. Insbesondere können vorangehend beschriebene Ausführungsbeispiele zur Formierung während der Herstellung von Batteriezellen genutzt werden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die steuerbare Energiequelle kann auch so angesteuert werden oder so gestaltet sein, dass die ermittelte Energiemenge durch Strompulse oder einen wellenförmigen Strom an die zu formierende Batterie geleitet wird. Die Anpassung der Energiemenge, wie sie in den Ausführungsbeispielen beschrieben wurde, kann dann durch eine Variation der Frequenz oder der Stromimpulshöhe bzw. der Amplitudengröße erfolgen.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (500) zum Formieren einer Batterie (24) mit folgenden Schritten:
Erhalten (510) eines Referenzenergieprofils für eine Formierung der Batterie (24) umfassend
Vergleichen (110) eines ersten Verlaufs (12), der eine Aufnahme einer elektrischen Größe einer ersten Batterie während eines ersten Ladezyklus beschreibt, mit einem zweiten Verlauf (14), der die Aufnahme der elektrischen Größe der ersten oder einer zweiten Batterie während eines zweiten Ladezyklus, der auf den ersten Ladezyklus folgt, beschreibt, für eine Vielzahl von Zeitintervallen (18a-d);
Bestimmen (120) einer Abweichung (16a-d) zwischen dem ersten (12) und dem zweiten (14) Verlauf für jedes der Vielzahl von Zeitintervalle (18a-d); und
Bestimmen (130) einer Menge der elektrischen Größe basierend auf der Abweichung (16a-d) für jedes der Zeitintervalle (18a-d), wobei die Menge der elektrischen Größe eine Sollvorgabe des Referenzenergieprofils für eine einer zu formierenden Batterie (24) zuzuführende Menge der elektrischen Größe während eines Formierungsprozesses der zu formierenden Batterie (24) für jedes der Zeitintervalle (18a-d) beschreibt; und
Laden (520) der Batterie (24) mit einer Menge einer elektrischen Größe, wobei ein zeitlicher Verlauf der Menge der elektrischen Größe auf dem Referenzenergieprofil basiert;
wobei das Bestimmen (120) der Menge der elektrischen Größe basierend auf einer Umrechnungsfunktion mit zumindest einem Funktionsargument erfolgt, wobei das Funktionsargument die bestimmte Abweichung (16a-d) ist, und wobei die elektrische Größe eine elektrische Stromstärke oder eine elektrische Ladungsmenge beschreibt.

2. Verfahren gemäß Anspruch 1, bei dem die Umrechnungsfunktion über den Formierungsprozess veränderlich ist.

3. Verfahren (500) zum Formieren einer Batterie (24) mit folgenden Schritten:
Erhalten (510) eines Referenzenergieprofils für eine Formierung der Batterie (24) umfassend
Vergleichen (210) eines ersten Verlaufs (12), der eine Aufnahme einer elektrischen Größe einer ersten Batterie während eines ersten Ladezyklus beschreibt, mit einem zweiten Verlauf (14), der die Aufnahme der elektrischen Größe der ersten oder einer zweiten Batterie während eines zweiten Ladezyklus, der auf den ersten Ladezyklus folgt, beschreibt, für eine Vielzahl von Zeitintervallen (18a-d);
Bestimmen (220) einer Abweichung (16a-d) zwischen dem ersten (12) und dem zweiten (14) Verlauf für jedes der Vielzahl von Zeitintervallen; und
Bestimmen (230), dass eine Menge der elektrischen Größe, die einer weiteren Batterie (24) während einer Formierung derselben zugeführt wird, in einem Zeitintervall (18a-d) reduziert ist, basierend auf dem Vergleich, wenn der Vergleich anzeigt, dass ein Ausmaß einer Formierung, die von der elektrischen Größe bewirkt wird, größer oder gleich als 40 % einer durch die elektrische Größe bewirkbaren Formierung ist;
wobei ein Verlauf der Menge der elektrischen Größe über die Vielzahl von Zeitintervallen (18a-d) das Referenzenergieprofil zumindest teilweise beschreibt; und
Laden (520) der Batterie (24) mit einer Menge einer elektrischen Größe, wobei ein zeitlicher Verlauf der Menge der elektrischen Größe auf dem Referenzenergieprofil basiert.

4. Verfahren gemäß Anspruch 3, ferner umfassend:
Bestimmen eines Ausmasses, der von der zugeführten elektrischen Größe bewirkten Formierung gegenüber einer durch die elektrische Größe bewirkbaren Formierung unter Verwendung der Abweichung und unter Verwendung einer Messung an einer Referenzbatterie oder einer Simulation für einen entsprechenden Batterietyp.

5. Verfahren gemäß einem der vorangehenden Ansprüche, bei dem das Vergleichen (110; 210) des ersten (12) und des zweiten (14) Verlaufs folgenden Schritt umfasst:
Bestimmen (310) einer Ladungsmenge, die von der ersten oder zweiten Batterie aufgenommen oder abgegeben wird, für jedes der Vielzahl von Zeitintervallen (18a-d);
Bilden (320) eines Verhältnisses (dU/dQ) zwischen der aufgenommenen Ladungsmenge und einer Spannungsänderung, die eine Änderung einer an Batteriepolen der ersten Batterie anliegenden elektrischen Spannung beschreibt, für jedes der Vielzahl von Zeitintervallen (18a-d); oder
Bilden (320) eines Verhältnisses (dU/dQ) zwischen der aufgenommenen Ladungsmenge und einer Spannungsänderung, die eine Änderung einer an Batteriepolen der zweiten Batterie anliegenden elektrischen Spannung beschreibt, für jedes der Vielzahl von Zeitintervallen (18a-d).

6. Verfahren gemäß einem der vorangehenden Ansprüche, bei dem der erste Ladezyklus der zeitlich erste Ladezyklus ist, während dem die erste Batterie geladen wird, und bei dem auf den ersten Ladezyklus eine Entladung der ersten Batterie folgt und bei dem auf die Entladung der zweite Ladezyklus folgt.

7. Verfahren gemäß einem der vorangehenden Ansprüche, bei dem sich die Vielzahl von Zeitintervallen (18a-d) auf eine zeitliche Dauer des ersten oder zweiten Ladezyklus bezieht und eine Anzahl von zumindest 3 Zeitintervallen (18a-d) pro Stunde umfasst.

8. Verfahren gemäß einem der vorangehenden Ansprüche, bei dem eine zeitliche Dauer zumindest eines der Vielzahl von Zeitintervallen (18a-d) mit einer Zeitspanne korreliert, innerhalb der eine an der ersten oder zweiten Batterie anliegende elektrische Spannung innerhalb eines Toleranzbereichs von zumindest 0,1 % und höchstens 30 % unverändert ist.

9. Verfahren gemäß einem der vorangehenden Ansprüche, bei dem das Verfahren in zumindest einer Wiederholung wiederholt ausgeführt wird, wobei der erste Verlauf (12) und der zweite Verlauf (14) einer jeweiligen Wiederholung einem Lade- oder Entladezyklus der zu formierenden Batterie (24) zugeordnet sind und wobei der erste Verlauf (12) oder der zweite Verlauf (14) einer Wiederholung gegenüber dem ersten Verlauf (12) bzw. gegenüber dem zweiten Verlauf (14) einer vorangehenden Ausführung des Verfahrens verändert sind und wobei für wiederholte Lade- oder Entladezyklen der Batterie jeweils ein Referenzstromprofil erstellt wird.

10. Verfahren gemäß einem der vorangehenden Ansprüche, bei dem der zeitliche Verlauf eine Vielzahl von Zeitintervallen (18a-d) umfasst, die mit einer Zeitspanne korrelieren, innerhalb der eine an der ersten oder zweiten Batterie anliegende elektrische Spannung innerhalb eines Toleranzbereichs von zumindest 0,1 % und höchstens 30 % unverändert ist.

11. Verfahren gemäß einem der vorangehenden Ansprüche, das ferner folgende Schritte umfasst:
Bestimmen einer ersten physikalischen Größe der Batterie (24) zu einem ersten Zeitpunkt (t₁);
Unterbrechen des Ladens der Batterie (24) und Bestimmen der ersten physikalischen Größe der Batterie (24) zu einem zweiten Zeitpunkt (t₂), der auf den ersten Zeitpunkt (t₁) folgt;
Bestimmen einer Abweichung zwischen der ersten physikalischen Größe zum ersten Zeitpunkt und der ersten physikalischen Größe zum zweiten Zeitpunkt;
Korrigieren des Referenzenergieprofils basierend auf der bestimmten Abweichung; und
Wiederaufnahme des Ladens oder Entladens.

12. Verfahren gemäß einem der vorangehenden Ansprüche, wobei es sich bei der Menge der elektrischen Größe um eine elektrische Stromstärke und/oder eine elektrische Ladungsmenge und/oder eine elektrische Spannung handelt, die zu einem Laden oder Entladen der zu formierenden Batterie führt.

13. Vorrichtung (70; 80) zum Formieren einer Batterie (24) mit folgenden Merkmalen:
einer steuerbaren Energiequelle (28), die ausgebildet ist, um eine elektrische Größe an eine mit der steuerbaren Energiequelle (28) gekoppelte Batterie (24) zu liefern, um die Batterie (24) zu formieren;
einer Steuereinrichtung (34; 34'), die ausgebildet ist, um die steuerbare Energiequelle (28) in einer Vielzahl von Zeitintervallen (18a-d) zu steuern, um die Batterie (24) während der Vielzahl von Zeitintervallen (18a-d) zu formieren;
einer Erfassungseinrichtung (36), die ausgebildet ist, um einen physikalischen Zustand der Batterie (24) in jedem der Zeitintervalle (18a-d) zu bestimmen, um einen erfassten physikalischen Zustand zu erhalten;
wobei die Steuereinrichtung (34; 34') ausgebildet ist, um basierend auf dem erfassten physikalischen Zustand die steuerbare Energiequelle (28) so zu steuern, dass eine Menge der elektrischen Größe, die während eines folgenden Zeitintervalls (18a-d) an die Batterie (24) geliefert wird erhöht oder gesenkt wird;
wobei die Vorrichtung (80) einen Speicher (38) aufweist, der ausgebildet ist, um ein Referenzenergieprofil zu speichern, das für die der Batterie (24) bereitzustellenden elektrischen Größe und den physikalischen Zustand eine Sollwertvorgabe für jedes der Vielzahl von Zeitintervallen (18a-d) eines Ladezyklus aufweist;
wobei die Steuereinrichtung (34') ausgebildet ist, um die steuerbare Energiequelle (28) so zu steuern, dass diese die Batterie (24) basierend auf den Sollwertvorgaben der elektrischen Größe lädt;
wobei die Steuereinrichtung (34') ausgebildet ist, um für jedes der Vielzahl von Zeitintervallen (18a-d) eine Abweichung (16a-d) zwischen dem erfassten physikalischen Zustand der Batterie (24) und der Sollwertvorgabe des physikalischen Zustands zu bestimmen;
wobei die Steuereinrichtung (34') ausgebildet ist, um die steuerbare Energiequelle (28) abweichend von der Sollwertvorgabe für die elektrische Größe so zu steuern, dass die Batterie (24) mit einem geringeren oder höheren Maß der elektrischen Größe geladen wird, wenn die Abweichung (16a-d) zwischen der Sollwertvorgabe des physikalischen Zustandes und dem erfassten physikalischen Zustand größer ist, als zumindest 1 %;
wobei sich der physikalische Zustand zumindest teilweise auf eine Spannungsänderung (dU) der an Batteriepolen der Batterie (24) anliegenden elektrischen Spannung im Verhältnis zu einer von der Batterie (24) aufgenommenen Ladungsmenge (dQ) bezieht.

14. Vorrichtung gemäß Anspruch 13, bei der sich der physikalische Zustand auf zumindest eines aus einer elektrischen Spannung (U), die an Batteriepolen der Batterie (24) anliegt, einer elektrischen Stromstärke, die an die Batterie (24) geführt wird, einer elektrischen Ladungsmenge (Q), die von der Batterie (24) aufgenommen wird, eine Zeitdauer, in der eine elektrische Größe von der Batterie (24) aufgenommen wird, und einer Temperatur, die an oder in der Batterie (24) anliegt, bezieht.

15. Vorrichtung gemäß Anspruch 13 oder 14, bei der die Steuereinrichtung (34') ausgebildet ist, um einen Wert des erfassten physikalischen Zustands einer Energiegröße zuzuordnen und um die steuerbare Energiequelle (28) so zu steuern, dass die steuerbare Energiequelle (28) die bestimmte Energiegröße der Batterie (24) innerhalb eines folgenden Zeitintervalls (18a-d) bereitstellt.

## Claims

1. A method (500) of forming a battery (24), comprising the steps of:
obtaining (510) a reference energy profile for forming the battery (24), including
comparing (110) a first course (12) which describes absorption of an electrical quantity of a first battery during a first charge cycle, to a second course (14) which describes absorption of the electrical quantity of the first or a second battery during a second charge cycle which follows the first charge cycle, for a plurality of time intervals (18a-d);
determining (120) a deviation (16a-d) between the first (12) and the second course (14) for each of the plurality of time intervals (18a-d); and
determining (130) an amount of the electrical quantity on the basis of the deviation (16a-d) for each of the time intervals (18a-d), wherein the amount of the electrical quantity describes a preset default value of the reference energy profile for an amount of the electrical quantity to be fed to a battery (24) to be formed during a formation process of the battery (24) to be formed, for each of the time intervals (18a-d); and
charging (520) the battery (24) with an amount of an electrical quantity, wherein a temporal course of the amount of the electrical quantity is based on the reference energy profile,
wherein said determining (120) of the amount of the electrical quantity takes place on the basis of a conversion function having at least one function argument, the function argument being the deviation (16a-d) determined, and wherein the electrical quantity describes an electrical current intensity or an amount of electrical charge.

2. The method in accordance with claim 1, wherein the conversion function is variable over the formation process.

3. A method (500) of forming a battery (24), comprising the steps of:
obtaining (510) a reference energy profile for forming the battery (24), including
comparing (210) a first course (12) which describes absorption of an electrical quantity of a first battery during a first charge cycle, to a second course (14) which describes absorption of the electrical quantity of the first or a second battery during a second charge cycle which follows the first charge cycle, for a plurality of time intervals (18a-d);
determining (220) a deviation (16a-d) between the first (12) and the second course (14) for each of the plurality of time intervals; and
determining (230) that an amount of the electrical quantity fed to another battery (24) during formation thereof is reduced in a time interval (18a-d), on the basis of the comparison when the comparison indicates that an extent of a formation caused by the electrical quantity is smaller than or equaling 80 % of a formation causable by the electrical quantity;
wherein a course of the amount of the electrical quantity at least partially describes the reference energy profile over the plurality of time intervals (18a-d); and
charging (520) the battery (24) with an amount of an electrical quantity, wherein a temporal course of the amount of the electrical quantity is based on the reference energy profile.

4. The method in accordance with claim 3, further comprising:
determining an extent of the formation caused by the electrical quantity supplied as compared to a formation that may be caused by the electrical quantity, while using the deviation and using a measurement at a reference battery or a simulation for a corresponding battery type.

5. The method in accordance with any of the preceding claims, wherein comparing (110; 210) the first (12) and second (14) courses further comprises the step of:
determining (310) an amount of charge absorbed or released by the first or second battery, for each of the plurality of time intervals (18a-d);
establishing (320) a ratio (dU/dQ) between the amount of charge absorbed and a change in voltage, which describes a change in an electrical voltage applied to battery poles of the first battery, for each of the plurality of time intervals (18a-d); or
establishing (320) a ratio (dU/dQ) between the amount of charge absorbed and a change in voltage, which describes a change in an electrical voltage applied to battery poles of the second battery, for each of the plurality of time intervals (18a-d).

6. The method in accordance with any of the preceding claims, wherein the first charge cycle is the temporally first charge cycle during which the first battery is charged, and wherein the first charge cycle is followed by discharge of the first battery, and wherein said discharge is followed by the second charge cycle.

7. The method in accordance with any of the preceding claims, wherein the plurality of time intervals (18a-d) relates to a temporal duration of the first or second charge cycle and comprises a number of at least three time intervals (18a-d) per hour.

8. The method in accordance with any of the preceding claims, wherein a temporal duration of at least one of the plurality of time intervals (18a-d) correlates with a time span within which an electrical voltage applied to the first or second battery remains unchanged within a tolerance range of at least 0.1 % and at most 30 %.

9. The method in accordance with any of the preceding claims, wherein the method is performed repeatedly in at least one iteration, wherein the first course (12) and the second course (14) of a respective iteration are associated with a charge or discharge cycle of the battery (24) to be formed, and wherein the first course (12) and the second course (14) of an iteration are changed as compared to the first course (12) and to the second course (14), respectively, of a previous execution of the method, and wherein a reference current profile is established for each of iterated charge or discharge cycles.

10. The method in accordance with any of the preceding claims, wherein the temporal course includes a plurality of time intervals (18a-d) which correlate with a time span within which an electrical voltage applied to the first or second battery remains unchanged within a tolerance range of at least 0.1 % and at most 30 %.

11. The method in accordance with any of the preceding claims, further comprising the steps of:
determining a first physical quantity of the battery (24) at a first point in time (t₁);
interrupting charging of the battery (24) and determining the first physical quantity of the battery (24) at a second point in time (t₂) following the first point in time (t₁);
determining a deviation between the first physical quantity at the first point in time and the first physical quantity at the second point in time;
correcting the reference energy profile on the basis of the deviation determined; and
resuming charging or discharging.

12. The method in accordance with any of the preceding claims, wherein the amount of the electrical quantity is an electrical current intensity and/or an amount of electrical charge and/or an electrical voltage which result(s) in charging or discharging of the battery to be formed.

13. A device (70; 80) for forming a battery (24), comprising:
a controllable energy source (28) configured to provide an electrical quantity to a battery (24) coupled to the controllable energy source (28) so as to form the battery (24);
control means (34; 34') configured to control the controllable energy source (28) in a plurality of time intervals (18a-d) so as to form the battery (24) during the plurality of time intervals (18a-d);
detection means (36) configured to determine a physical state of the battery (24) within each of the time intervals (18a-d),
wherein the control means (34; 34') is configured to control the controllable energy source (28), on the basis of the physical state detected, such that an amount of the electrical quantity provided to the battery (24) during a subsequent time interval (18a-d) is increased or decreased,
wherein the device (80) comprises a memory (38) configured to store a reference energy profile comprising a preset default value for each of the plurality of time intervals (18a-d) of a charge cycle for the electrical quantity to be provided to the battery (24) and for the physical state;
wherein the control means (34') is configured to control the controllable energy source (28) such that the latter charges the battery (24) on the basis of the preset default values of the electrical quantity;
wherein the control means (34') is configured to determine a deviation (16a-d) between the physical state of the battery (24) detected and the preset default value of the physical state for each of the plurality of time intervals (18a-d);
wherein the control means (34') is configured to control the controllable energy source (28), in a manner deviating from the preset default value for the electrical quantity, such that the battery (24) is charged with a lower or higher measure of the electrical quantity when the deviation (16a-d) between the preset default value of the physical state and the physical state detected is larger than at least 1 %;
wherein the physical state relates at least partly to a change in voltage (dU) of the electrical voltage applied to battery poles of the battery (24) in relation to an amount of charge (dQ) absorbed by the battery (24).

14. The device in accordance with claim 13, wherein the physical state relates to at least one of an electrical voltage (U) applied to battery poles of the battery (24), an electrical current intensity supplied to the battery (24), an amount of electrical charge (Q) absorbed by the battery (24), a duration during which an electrical quantity is absorbed by the battery (24), and a temperature applied at or within the battery (24).

15. The device in accordance with claim 13 or 14, wherein the control means (34') is configured to associate a value of the physical state detected with an energy quantity and to control the controllable energy source (28) such that the controllable energy source (28) provides the energy quantity determined to the battery (24) within a subsequent time interval (18a-d).

## Revendications

1. Procédé (500) de formation d'une batterie (24), aux étapes suivantes consistant à:
obtenir (510) un profil d'énergie de référence pour une formation de la batterie (24), comprenant le fait de
comparer (110) une première évolution (12) qui décrit une réception d'une grandeur électrique d'une première batterie pendant un premier cycle de charge avec une deuxième évolution (14) qui décrit la réception de la grandeur électrique de la première ou d'une deuxième batterie pendant un deuxième cycle de charge qui suit le premier cycle de charge, pour une pluralité d'intervalles de temps (18a à d);
déterminer (120) un écart (16a à d) entre la première (12) et la deuxième (14) évolution pour chacun de la pluralité d'intervalles de temps (18a à d); et
déterminer (130) une quantité de la grandeur électrique sur base de l'écart (16a à d) pour chacun des intervalles de temps (18a à d), la quantité de la grandeur électrique décrivant une valeur de consigne du profil d'énergie de référence pour une quantité de la grandeur électrique à alimenter vers la batterie (24) à former pendant un processus de formation de la batterie (24) à former pour chacun des intervalles de temps (18a à d); et
charger (520) la batterie (24) d'une quantité d'une grandeur électrique, une évolution dans le temps de la quantité de la grandeur électrique étant basée sur le profil d'énergie de référence,
dans lequel la détermination (120) de la quantité de la grandeur électrique a lieu sur base d'une fonction de conversion avec au moins un argument de fonction, l'argument de fonction étant l'écart déterminé (16a à d), et dans lequel la grandeur électrique décrit une intensité de courant électrique ou une quantité de charge électrique.

2. Procédé selon la revendication 1, dans lequel la fonction de conversion est variable au cours du processus de formation.

3. Procédé (500) de formation d'une batterie (24), aux étapes suivantes consistant à:
obtenir (510) un profil d'énergie de référence pour une formation de la batterie (24), comprenant le fait de
comparer (210) une première évolution (12) qui décrit une réception d'une grandeur électrique d'une première batterie pendant un premier cycle de charge avec une deuxième évolution (14) qui décrit la réception de la grandeur électrique de la première ou d'une deuxième batterie pendant un deuxième cycle de charge qui suit le premier cycle de charge, pour une pluralité d'intervalles de temps (18a à d);
déterminer (220) un écart (16a à d) entre la première (12) et la deuxième (14) évolution pour chacun de la pluralité d'intervalles de temps; et
déterminer (230) qu'une quantité de quantité grandeur électrique qui est alimentée vers une autre batterie (24) pendant une formation de cette dernière est réduite dans un intervalle de temps (18a à d) sur base de la comparaison lorsque la comparaison indique qu'une mesure d'une formation qui est provoquée par la grandeur électrique est supérieure ou égale à 40% d'une formation pouvant être générée par la grandeur électrique;
dans lequel une évolution de la quantité de la grandeur électrique pendant la pluralité d'intervalles de temps (18a à d) décrit au moins partiellement le profil d'énergie de référence; et
charger (520) la batterie (24) d'une quantité d'une grandeur électrique, une évolution dans le temps de la quantité de la grandeur électrique étant basée sur le profil d'énergie de référence.

4. Procédé selon la revendication 3, comprenant par ailleurs le fait de:
déterminer une mesure de la formation provoquée par la grandeur électrique alimentée par rapport à une formation pouvant être provoquée par la grandeur électrique à l'aide de l'écart et à l'aide d'une mesure à une batterie de référence ou d'une simulation pour un type de batterie correspondant.

5. Procédé selon l'une des revendications précédentes, dans lequel la comparaison (110; 210) de la première (12) et de la deuxième (14) évolution comporte l'étape suivante consistant à:
déterminer (310) une quantité de charge qui est reçue ou délivrée par la première ou la deuxième batterie pour chacun de la pluralité d'intervalles de temps (18a à d);
former (320) un rapport (dU/dQ) entre la quantité de charge reçue et un changement de tension qui décrit un changement d'une tension électrique présente aux pôles de la première batterie pour chacun de la pluralité d'intervalles de temps (18a à d); ou
former (320) un rapport (dU/dQ) entre la quantité de charge reçue et un changement de tension qui décrit un changement d'une tension électrique présente aux pôles de la deuxième batterie pour chacun de la pluralité d'intervalles de temps (18a à d).

6. Procédé selon l'une des revendications précédentes, dans lequel le premier cycle de charge est le premier cycle de charge dans le temps pendant lequel est chargée la première batterie et dans lequel le premier cycle de charge est suivi d'une décharge de la première batterie et dans lequel la décharge est suivie du deuxième cycle de charge.

7. Procédé selon l'une des revendications précédentes, dans lequel la pluralité d'intervalles de temps (18a à d) se rapporte à une durée dans le temps du premier ou du deuxième cycle de charge et comporte un nombre d'au moins 3 intervalles de temps (18a à d) par heure.

8. Procédé selon l'une des revendications précédentes, dans lequel une durée dans le temps d'au moins l'un de la pluralité d'intervalles de temps (18a à d) est corrélée avec un intervalle de temps dans lequel est inchangée une tension électrique présente à la première ou à la deuxième batterie dans une plage de tolérances d'au moins 0,1 % et de tout au plus 30 %.

9. Procédé selon l'une des revendications précédentes, dans lequel le procédé est réalisé de manière répétée en au moins une répétition, dans lequel la première évolution (12) et la deuxième évolution (14) d'une répétition respective sont associées à un cycle de charge ou de décharge de la batterie (24) à former, et dans lequel la première évolution (12) ou la deuxième évolution (14) d'une répétition sont changées par rapport à la première évolution (12) ou par rapport à la deuxième évolution (14) d'une réalisation précédente et dans lequel est chaque fois établi un profil de courant de référence pour les cycles de charge ou de décharge répétés de la batterie.

10. Procédé selon l'une des revendications précédentes, dans lequel la durée comprend une pluralité d'intervalles de temps (18a à d) qui sont corrélés avec un laps de temps dans lequel une tension électrique présente à la première ou à la deuxième batterie est inchangée dans une plage de tolérances d'au moins 0,1 % et de tout au plus 30 %.

11. Procédé selon l'une des revendications précédentes, comportant par ailleurs les étapes suivantes consistant à:
déterminer une première grandeur physique de la batterie (24) à un premier moment (ti);
interrompre la charge de la batterie (24) et déterminer la première grandeur physique de la batterie (24) à un deuxième moment (t₂) qui suit le premier moment (t₁);
déterminer un écart entre la première grandeur physique au premier moment et la première grandeur physique au deuxième moment;
corriger le profil d'énergie de référence en fonction de l'écart déterminé; et
reprendre la charge ou la décharge.

12. Procédé selon l'une des revendications précédentes, dans lequel il s'agit, pour la quantité de la grandeur électrique, d'une intensité de courant électrique et/ou d'une quantité de charge électrique et/ou d'une tension électrique qui conduit à la charge ou décharge de la batterie à former.

13. Dispositif (70; 80) de formation d'une batterie (24), aux caractéristiques suivantes:
une source d'énergie pouvant être commandée (28) qui est configurée pour alimenter une grandeur électrique vers une batterie (24) couplée à la source d'énergie pouvant être commandée (28) pour former la batterie (24);
un moyen de commande (34; 34') qui est conçu pour commander la source d'énergie pouvant être commandée (28) en une pluralité d'intervalles de temps (18a à d) pour former la batterie (24) pendant la pluralité d'intervalles de temps (18a à d);
un moyen de détection (36) qui est conçu pour déterminer une condition physique de la batterie (24) dans chacun des intervalles de temps (18a à d);
dans lequel le moyen de commande (34; 34') est conçu pour commander, sur base de la condition physique détectée, la source d'énergie pouvant être commandée (28) de sorte que soit augmentée ou diminuée une quantité de la grandeur électrique qui est alimentée vers la batterie (24) pendant un intervalle de temps (18a à d) suivant;
dans lequel le dispositif (80) présente une mémoire (38) qui est conçue pour mémoriser un profil d'énergie de référence qui présente, pour la grandeur électrique à mettre à disposition pour la batterie (24) et pour la condition physique, une valeur de consigne pour chacun de la pluralité d'intervalles de temps (18a à d) d'un cycle de charge;
dans lequel le moyen de commande (34') est conçu pour commander la source d'énergie pouvant être commandée (28) de sorte que cette dernière charge la batterie (24) sur base des valeurs de consigne de la grandeur électrique;
dans lequel le moyen de commande (34') est conçu pour déterminer, pour chacun de la pluralité d'intervalles de temps (18a à d), un écart (16a à d) entre la condition physique détectée de la batterie (24) et la valeur de consigne de la condition physique;
dans lequel le moyen de commande (34') est conçu pour commander la source d'énergie pouvant être commandée (28), par dérogation à la valeur de consigne pour la grandeur électrique, de sorte que la batterie (24) soit chargée avec une mesure de la grandeur électrique qui est inférieure ou supérieure lorsque l'écart (16a à d) entre la valeur de consigne de la condition physique et la condition physique détectée est supérieur à au moins 1 %;
dans lequel la condition physique se réfère au moins partiellement à un changement de tension (dU) de la tension présente aux pôles de la batterie (24) par rapport à une quantité de charge (dQ) reçue par la batterie (24).

14. Dispositif selon la revendication 13,
dans lequel la condition physique se réfère à au moins l'un parmi une tension électrique (U) qui est présente aux pôles de la batterie (24), un intensité de courant électrique qui est alimentée vers la batterie (24), une quantité de charge électrique (Q) qui est reçue par la batterie (24), un laps de temps pendant lequel une grandeur électrique est reçue par la batterie (24), et une température qui est présente à ou dans la batterie (24).

15. Dispositif selon la revendication 13 ou 14,
dans lequel le moyen de commande (34') est conçu pour associer une valeur de la condition physique détectée à une grandeur d'énergie et pour commander la source d'énergie pouvant être commandée (28) de sorte que la source d'énergie pouvant être commandée (28) mette la grandeur d'énergie déterminée à disposition la de la batterie (24) dans un intervalle de temps suivant (18a à d).
